(19) Europäisches Patentamt
European Patent Office
Office européen des brevets

(11) EP 2 606 076 B1

(12) **EUROPÄISCHE PATENTSCHRIFT**

(45) Veröffentlichungstag und Bekanntmachung des Hinweises auf die Patenterteilung:
**21.12.2016 Patentblatt 2016/51**

(21) Anmeldenummer: **11738953.6**

(22) Anmeldetag: **30.06.2011**

(51) Int Cl.:
***C08F 212/14*** (2006.01) ***C09D 125/08*** (2006.01)
***C08J 3/24*** (2006.01) ***H01L 51/00*** (2006.01)
***C08G 59/32*** (2006.01) ***C08G 59/62*** (2006.01)

(86) Internationale Anmeldenummer:
**PCT/EP2011/003239**

(87) Internationale Veröffentlichungsnummer:
**WO 2012/022390 (23.02.2012 Gazette 2012/08)**

(54) **VERFAHREN ZUR HERSTELLUNG DURCHSCHLAGFESTER ULTRADÜNNER DIELEKTRIKA IN ELEKTRONISCHEN BAUTEILEN UNTER VERWENDUNG VERNETZBARER POLYMERER DIELEKTRISCHER MATERIALIEN**

PROCESS FOR PRODUCING BREAKDOWN-RESISTANT ULTRATHIN DIELECTRICS IN ELECTRONIC COMPONENTS USING CROSSLINKABLE POLYMERIC DIELECTRIC MATERIALS

PROCÉDÉ DE RÉALISATION D'UN DIÉLECTRIQUE ULTRA-MINCE RÉSISTANT À LA PERFORATION DANS DES COMPOSANTS ÉLECTRONIQUES À L'AIDE DE MATÉRIAUX DIÉLECTRIQUES POLYMÈRES RÉTICULABLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.08.2010 DE 102010034577**

(43) Veröffentlichungstag der Anmeldung:
**26.06.2013 Patentblatt 2013/26**

(73) Patentinhaber:
- **Fraunhofer-Gesellschaft zur Förderung der angewandten Forschung e.V.**
**80686 München (DE)**
- **Technische Universität Darmstadt**
**64289 Darmstadt (DE)**

(72) Erfinder:
- **JANIETZ, Silvia**
**14532 Stahnsdorf (DE)**
- **SCHULZE, Kerstin**
**10245 Berlin (DE)**
- **EGOROV-BRENING, Tatjana**
**16761 Hennigsdorf (DE)**
- **VON SEGGERN, Heinz**
**64625 Bensheim (DE)**
- **KATHOLING, Eileen**
**14473 Potsdam (DE)**

(74) Vertreter: **Pfenning, Meinig & Partner mbB**
**Patent- und Rechtsanwälte**
**Theresienhöhe 11a**
**80339 München (DE)**

(56) Entgegenhaltungen:
**WO-A2-2006/086082 DE-A1-102007 044 872**
**JP-A- 60 134 234**

- **VINET F ET AL: "RESIST DESIGN FOR DRV DEVELOPED POSITIVE WORKING SYSTEMS IN DEEP UV AND A BEAM LITHOGRAPHY", PROCEEDINGS OF SPIE, THE INTERNATIONAL SOCIETY FOR OPTICAL ENGINEERING SPIE, USA, Bd. 1466, 1. Januar 1991 (1991-01-01), Seiten 558-569, XP000878746, ISSN: 0277-786X, DOI: 10.1117/12.46404**
- **YOON ET AL: "Low-Voltage Organic Field-Effect Transistors and Inverters Enabled by Ultrathin Cross-linked Polymers as Gate Dielectrics", JOURNAL OF THE AMERICAN CHEMICAL SOCIETY, AMERICAN CHEMICAL SOCIETY, WASHINGTON, DC; US, Bd. 127, 27. Juli 2005 (2005-07-27), Seiten 10388-10395, XP002408788, ISSN: 0002-7863, DOI: 10.1021/JA052488F**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 606 076 B1

## Beschreibung

Die vorliegende Erfindung betrifft die Herstellung und Verwendung von ultradünnen vernetzbaren Polymerschichten als durchschlagfestes Dielektrika. Diese lassen sich durch einfaches Abscheiden aus Lösungen realisieren und können anschließend durch thermische oder auch UV-Behandlung in der Schicht vernetzt werden.

Die Entwicklung von polymeren dielektrischen Materialien ist wichtig für den Fortschritt sowohl in traditionellen als auch organischen, elektronischen Bauteilen. Im Speziellen Anzeigeelemente und Kennzeichnungstechnologien basierend auf organischen DünnfilmTransistoren (engl.: organic thin film transistors (OTFTs)), wie z.B. Elektronisches Papier (E-Papier) und RFID-Transponder, erfordern die Herstellung von OTFTs auf flexiblen Plastiksubstraten über große Flächen und in hohen Stückzahlen. Deshalb gibt es auch beachtliche Anstrengungen, neue Materialien für OTFT-Komponenten, wie z.B. Halbleiter, Dielektrika und Kontakte, zu entwickeln, die sich aus Lösung, wie z.B. durch Spin-Coating, Gieß-Techniken und Drucken, abscheiden lassen. Eine Schlüsselanforderung für ein polymeres Gate-Dielektrika in OTFTs besteht darin, dünne Schichten mit guten dielektrischen Eigenschaften zu bilden. Die Schichtdicke des Gate-Dielektrikums bestimmt direkt die Betriebsspannung des Feldeffekttransistors. In einem typischen OTFT wird die Leitfähigkeit des Source-Drain-Kanals durch das an Source und Gate angelegte elektrische Feld moduliert. Befindet sich das Device im "OFF"-Zustand (Gatespannung $U_G = 0$ V), ist die Kanalleitfähigkeit sehr gering (typisch > $10^{12}$ Ωm) im "ON"-Zustand ($U_G < 0$ V für löcherleitende Materialien und $U_G > 0$ V für elektronenleitende Materialien) dagegen wird ein steiles Ansteigen in der Leitfähigkeit beobachtet (< $10^6$ Ωm). Der Ausgangsstrom (im Sättigungsbereich) zwischen Source und Drain ($I_{DS}$) ist in diesem Fall definiert durch:

$$I_{DS} = (W/(2L)C_i\mu \; (V_G - V_T)^2$$

mit
W: Kanalbreite
L: Länge des Kanals
p: Ladungsträgermobilität des Halbleiters
$C_i$: dielektrische Kapazität pro Fläche
$V_G$: Source-Gate Spannung
$V_T$: Schwellspannung

Daraus folgt, dass für eine bestimmte Geometrie und einen bestimmten Halbleiter Stromverstärkungen bei niedrigeren Betriebsspannungen erreicht werden können, wenn die Kapazität ($C_i$) erhöht wird. Hierbei ist die Kapazität wie folgt definiert:

$$C_i = \varepsilon_0 \times k/d$$

k: dielektrische Konstante
$\varepsilon_0$: Dielektrizitätskonstante des Vakuums
d: Schichtdicke des dielektrischen Materials

Somit wird die Kapazität größer, wenn die dielektrische Konstante ansteigt oder die Schichtdicke sich verringert. Jedoch ist für die meisten der isolierenden Polymere die dielektrische Konstante sehr gering (≈ 3-6). Zusätzlich müssen die meisten isolierenden Polymere sehr dick aufgebracht werden (≈ 1 μm), um Leckströme und elektrische Durchbrüche durch das Dielektrikum zu verhindern. Mit konventionellen polymeren Isolatoren, wie z.B. Polymethylmethacrylat (PMMA) oder Polystyren (PS) ist es ausgeschlossen, elektrisch dichte dielektrische Schichten ohne Pinholes und elektrische Durchschläge im Bereich von kleiner 100 nm Schichtdicke zu erzielen.

Gelingt es demnach, die Schichtdicke in den Bereich von < 100 nm zu verringern und trotzdem eine elektrisch dichte Schicht zu erzeugen, kann man bei Betriebsspannungen in einem Spannungsbereich von ≤ 12 V arbeiten. Bisherige aus der Literatur bekannte Konzepte setzen unter anderem auf komplizierte Blendsysteme, die aus einem Matrixpolymer, wie z.B. PMMA, PVA oder PS bestehen, und geben einen zusätzlichen Vernetzer, wie z.B. 1,6-Bis(trichlorsilyl)hexan dazu. Dabei entsteht ein zusätzliches sehr dichtes Netzwerk bestehend aus Alkylsilyloxygruppen. Damit gelingt es, durchschlagfeste, ultradünne, dielektrische Schichten (100-30 nm) in OTFTs zu erzeugen; (US 2008/0161464 A1, T. J. Marks, A. Facchetti, Z. Wang, H.-J. Choi; Organic Electronics 2009, 10, 174, Y.-Y. Noh, H. Sirringhaus; J. am. Chem. Soc. 2008, 130, 6878, T. J. Marks, A. Facchetti, Z. Wang, H.-J. Choi, C. Kim, Y.-G. Ha, Adv. Mat'. 2005, 17, 1705, A. Facchetti, M.-H. Yoon, T. J. Marks, J. am. Chem. Soc. 2005, 127, 10388, M.-H. Yoon, H. Yan, A. Facchetti, T.

J. Marks, WO 2006/086082 A2). Das Handhaben solcher Blendsysteme ist unter normalen Laborbedingungen nicht möglich, da eine sofortige Reaktion des sehr aktiven, hydrolyseempfindlichen Vernetzers spontan mit der Umgebungsfeuchte eintreten kann. Man sucht heute nach Lösungen, die ein einfaches Verarbeiten der Polymere aus Lösung mit verschiedenen Abscheidetechniken, wie z.B. Spin-Coating, Rakeln oder Drucktechniken unter normalen Umgebungsbedingungen, erlaubt und anschließend die Schicht durch eine einfache thermische oder UV-Vernetzung stabilisiert werden kann. Ein anderes Konzept setzt auf den Einsatz von selbstorganisierenden Monoschichten, die sich auf sehr dünnen abgeschiedenen metalloxidischen Oberflächen, wie z.B. $Al_2O_3$, $Ta_2O_3$, ZrO oder auch auf nativem oxidiertem Silizium abscheiden lassen. Die oxidische metallische Schicht ist unbedingt notwendig, um eine Verankerung der organischen Monolage auf der Oberfläche zu erreichen. So wurden Aryloxyoctadecyltrichlorsilane zur Ausbildung von Monolagen auf Plasma-behandeltem Silizium eingesetzt. Die Monolagen wiesen Schichtdicken im Bereich von 2,5 nm auf und es wurden funktionierende OTFTs mit Betriebsspannungen von 2 bis 3 V aufgebaut (Nature 2004, 431, 963, M. Klauk, M. Halik, U. Zschieschang, G. Schmid, C. Dehm, M. Schütz, ST. Maisch, F. Effenberger, M. Brunnbauer, F. Stellacci). Für die Abscheidung von Monolagen auf metallischen Oxiden, wie z.B. $Al_2O_3$, wurden langkettige Organophosphate, wie z.B. Octadecylphosphonsäuren, eingesetzt und die halbleitende Schicht aufgedampft. (Nature 2007, 445, 745, H. Klauk, U. Zschieschang, U.

Halik, U. Pflaum; J. of Phys. Chem. A, 2007, 111, 12333, J. E. McDermott, M. McDowell, I. G. Hill, J. Hwang, A. Kahn, S. L. Bernasek, J. Schwartz). Auf Plastiksubstraten, wie PET, PEN oder Polyimid lassen sich diese selbstorganisierenden Monolagen nicht abscheiden. Außerdem besteht die Begrenzung dieser speziell hergestellten Dielektrika darin, dass es nur möglich ist, Bottom-Gate OTFT-Architekturen aufzubauen. Es wurde bisher auch immer der organische Halbleiter aufgedampft. Das Aufbringen des organischen Halbleiters aus Lösung wurde bisher damit noch nicht realisiert.

Die DE 10 2007 044872 A1 betrifft polymere Licht emittierende Dioden (PLEDs), die mindestens eine transparente Elektrode als Anode, mindestens eine Metallelektrode als Kathode sowie ein organisches, Licht emittierendes Mehrschichtsystem aus thermisch vernetzten Polymerschichten enthalten. Außerdem wird dabei ein Verfahren zur Herstellung solcher PLEDs beschrieben, bei dem ein Substrat mit einem Copolymer beschichtet und das Copolymer im Anschluss ausgehärtet wird.

In der JP 60 134234 A wird ein Copolymer bestehend aus p-hydroxystyrol und p-glycidetherstyrol beschrieben, welches mit ionisierender Strahlung quervernetzt wird.

Somit war es Aufgabe der vorliegenden Erfindung, ein Polymersystem anzugeben, aus dem sich besonders durchschlagsfeste Beschichtungen, beispielsweise für elektronische Bauteile, herstellen lassen. Ebenso war es Aufgabe der vorliegenden Erfindung, ein Verfahren zur Beschichtung eines Substrates herzustellen, wobei das Substrat mit einer durchschlagsfesten dielektrischen Schicht versehen werden kann. Zudem ist es Aufgabe der vorliegenden Erfindung, ein entsprechendes Substrat, insbesondere in Form eines elektronischen Bauteils, wie z.B. eine Diode bzw. ein OTFT, anzugeben.

Diese Aufgabe wird bezüglich eines elektronischen Bauteils mit den Merkmalen des Patentanspruchs 1, bezüglich eines unvernetzten Copolymeren mit den Merkmalen des Patentanspruchs 6, bezüglich eines quervernetzten Copolymeren, das sich aus dem zuvor genannten unvernetzten Copolymeren herstellen lässt, mit den Merkmalen des Patentanspruchs 9 sowie eines mit einem quervernetzten, Copolymeren beschichteten Substrates mit den Merkmalen des Patentanspruchs 10 gelöst. Die jeweiligen abhängigen Patentansprüche stellen dabei vorteilhafte Weiterbildungen dar.

Die hier beschriebenen unvernetzten Copolymere, die die oben genannten mindestens drei Wiederholungseinheiten aufweisen, sowie die hieraus abgeleiteten vernetzten Copolymere eignen sich insbesondere für das oben beschriebene Verfahren bzw. als dielektrische Materialien für das Substrat bzw. das elektronische Bauteil.

Es wird somit ein Verfahren zur Beschichtung eines Substrates angegeben, bei dem mindestens eine Oberfläche des Substrates mit einer mindestens ein Copolymer, enthaltend zumindest die beiden nachfolgend abgebildeten Wiederholungseinheiten A und B:

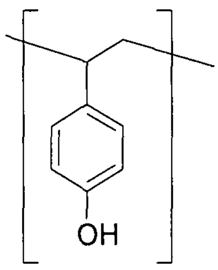

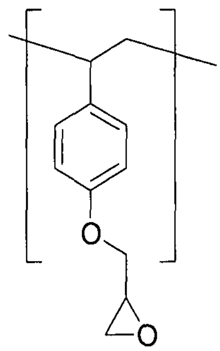

A B

und/oder ein zuvor beschriebenes Copolymer enthaltenden Lösung benetzt und anschließend das Copolymer bei Temperaturen zwischen 80 und 300 °C, bevorzugt zwischen 120 und 200 °C thermisch quervernetzt und/oder durch UV-Bestrahlung quervernetzt wird.

Das Verfahren verwendet dabei unvernetzte Copolymere zur Beschichtung von Substratoberflächen. Das erfindungsgemäße Verfahren umfasst die Möglichkeit, dass ein Copolymer, das aus den Wiederholungseinheiten A und B besteht (wobei das entsprechende Copolymer H-terminiert ist), als alleiniges Copolymer zur Beschichtung eingesetzt wird. In dieser Ausführungsform ist es bevorzugt, wenn das molare Verhältnis der Wiederholungseinheiten A/(A+B) zwischen 0,1 und 0,9, bevorzugt zwischen 0,2 und 0,8, weiter bevorzugt zwischen 0,4 und 0,6, besonders bevorzugt zwischen 0,45 und 0,55 beträgt.

Alternativ hierzu können ebenso die weiter unten stehend beschriebenen Copolymere, die mindestens 3 verschiedene Wiederholungseinheiten aufweisen, z.B. zusätzlich zu den Wiederholungseinheiten A+B noch weitere Einheiten C, D, E, F, G und/oder H, in Lösung eingesetzt werden.

Ebenso ist es jedoch möglich, dass mehrere der zuvor definierten Copolymere als Mischung miteinander zur Beschichtung des Substrates eingesetzt werden können. Dabei liegen mehrere der zuvor genannten Copolymere gemeinsam in der eingesetzten Lösung vor.

In einer weiter bevorzugten Ausführungsform enthält die Lösung 0,1 bis 30 Gew.-%, bevorzugt 0,5 bis 10 Gew.-% des mindestens einen Copolymeren.

Für den Fall, dass beispielsweise eine thermische Vernetzung vermieden werden soll und eine besonders bevorzugte Vernetzung mittels UV-Bestrahlung des eingesetzten Copolymeren stattfinden soll, erweist es sich insbesondere als vorteilhaft, wenn die Lösung

zusätzlich mindestens einen Fotoinitiator, bevorzugt einen Fotoinitiator ausgewählt aus der Gruppe bestehend aus Diphenyliodoniumtetrafluoroborat und/oder Triphenylsulfoniumhexafluoroantimonat enthält. Es ist dabei ausreichend, wenn der Fotoinitiator in katalytischen Mengen zugesetzt wird.

Der Benetzungsvorgang kann beispielsweise durch Spin-Coating, Dip-Coating, Doctor-Blade-Coating, Rakeln, Drucken und/oder Aufsprühen erfolgen.

Besonders geeignete Lösungsmittel, die zur Lösung des eingesetzten Copolymeren verwendet werden, sind dabei ausgewählt aus der Gruppe bestehend aus Ketonen, insbesondere Methylethylketon; organischen Estern und/oder Alkoholen, insbesondere Methanol, Ethanol, Propanol und/oder Butanol.

Der Vernetzungsprozess kann dabei vor dem Abdampfen der Lösungsmittel initiiert und durchgeführt werden, ebenso ist es jedoch auch möglich, zunächst das Lösungsmittel abzudampfen und das zurückbleibende unvernetzte Copolymer zu vernetzen.

Ebenso wird ein Substrat angegeben, das sich nach dem im Voranstehenden beschriebenen Verfahren herstellen lässt. Das Substrat weist dabei auf mindestens einer seiner Seiten mindestens eine Schicht auf, die ein quervernetztes Copolymer enthält. Wie im Detail noch weiter unten stehend näher ausgeführt wird, lässt sich das quervernetzte Copolymer durch thermische Quervernetzung bei Temperaturen zwischen 100 und 300 °C und/oder durch photoinitiierte Quervernetzung unter UV-Bestrahlung eines Copolymers, enthaltend zumindest die beiden nachfolgend abgebildeten Wiederholungseinheiten A und B:

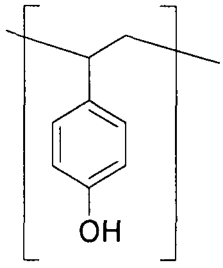

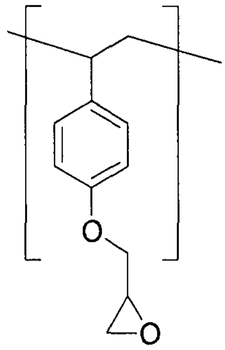

A B

herstellen, wobei die gleichen Reaktionsmechanismen wie weiter unten im Detail dargestellt, zum Tragen kommen. Ein erfindungsgemäßes Substrat wird in Patentanspruch 10 angegeben. Hierbei weist die das quervernetzte Copolymer enthaltende Schicht ein entsprechend quervernetztes Copolymer, das mindestens 3 Wiederholungseinheiten umfasst, auf. Ein entsprechendes quervernetztes Copolymer ist beispielsweise in Anspruch 9 beschrieben und lässt sich aus den in den Ansprüchen 6 bis 8 beschriebenen Copolymeren herstellen.

Das Substrat kann dabei selbst in direktem Kontakt mit dem Copolymeren stehen, ebenso ist es jedoch möglich, dass zwischen Substrat und Copolymer noch mindestens eine weitere Schicht, beispielsweise aus einem organischen Halbleiter, vorhanden ist. Auf diese Ausführungsform wird nachfolgend im Rahmen des beschriebenen elektronischen Bauteils noch näher eingegangen; die Ausführungen bezüglich des organischen Halbleiters gelten jedoch auch an dieser Stelle für das erfindungsgemäße Substrat. In jedem Fall wird erfindungsgemäß unter einem beschichteten Substrat jedoch eine Anordnung verstanden, die ein Substrat sowie eine Schicht eines Copolymeren aufweist.

Das erfindungsgemäße Substrat resultiert somit aus einem Hybrid, der aus einer Quervernetzung der oben angegebenen Typen von unvernetzten Copolymeren, d.h. dem Quervernetzungsprodukt eines Copolymeren, das aus den Wiederholungseinheiten A + B besteht, sowie mindestens einem weiteren Copolymeren, das mindestens eine weitere Wiederholungseinheit umfasst.

Besonders vorteilhaft ist dabei, wenn die Schichtdicke der Copolymer enthaltenden Schicht zwischen 10 und 1.000 nm, bevorzugt zwischen 20 und 500 nm, besonders bevorzugt zwischen 20 und 150 nm beträgt.

Bei bereits derartig geringen Schichtdicken lässt sich überraschenderweise beobachten, dass die Copolymerschichten durchschlagsfeste, dielektrische Eigenschaften aufweisen.

Weiter ist es vorteilhaft, wenn das Substrat ausgewählt ist aus der Gruppe bestehend aus Glassubstraten, mit Indium-Zinnoxid beschichteten Glassubstraten, wobei die Polymer enthaltende Schicht auf der Indium-Zinnoxidschicht aufgebracht ist, Polymersubstraten, bevorzugt folienförmigen Polymersubstraten, wobei das Polymer bevorzugt ausgewählt ist aus der Gruppe bestehend aus thermoplastischen Polymeren, insbesondere Polyestern, besonders bevorzugt Polyethylenterephthalat und/oder Silicum-Substrate, wie z.B. Silicium-Wafern.

Erfindungsgemäß wird ebenso ein elektronisches Bauteil mit den Merkmalen des Patentanspruchs 1 bereitgestellt.

In dieser besonders bevorzugten Ausführungsform der vorliegenden Erfindung ist das Substrat mit einem organischen Halbleiter beschichtet, wobei die das Copolymer enthaltende Schicht auf der dem Substrat abgewandten Seite der Halbleiterschicht aufgebracht ist (d.h. die Copolymerschicht ist auf der Halbleiterschicht aufgebracht), mit der Maßgabe, dass in die Schicht des organischen Halbleiters oder zwischen der Schicht des organischen Halbleiters und der das Copolymer enthaltenden Schicht mindestens eine Elektrode eingebettet ist.

Besondere Ausführungsformen der Erfindung sehen vor, dass das elektronische Bauteil z.B. als Diode oder als Feldeffekttransistor (in diesem Fall sind im organischen Halbleiter oder zwischen organischem Halbleiter und der Copolymer-enthaltenden Schicht mindestens zwei Elektroden eingebettet) ausgebildet ist.
Ein derartiger Feldeffekttransistor eignet sich insbesondere als OTFT.

Bei einem derartigen Bauteil, insbesondere bei einer derartigen Diode bzw. einem derartigen Feldeffekttransistor, ist es bevorzugt, wenn der organische Halbleiter ausgewählt ist aus der Gruppe bestehend aus

- linear kondensierten Ringsystemen, insbesondere Oligoacenen, wie Anthracen, Pentacen und dessen Derivaten (z. B. Chinacridon) und/oder Benzenthiolaten;

- zweidimensional kondensierten Ringsystemen, insbesondere Perylen, 3,4,9,10-Perylentetracarbonsäuredianhydrid (PTCDA) und dessen Derivaten, Naphthalin-Derivaten und/oder Hexabenzocoronen;
- Metallkomplexen, insbesondere Phthalocyaninen, oder Aluminium-tris(8-hydroxychinolin) und/oder Berylliumbis(hydroxybenzochinolin);
- dendritischen Molekülen, insbesondere 4,4',4"-tris(N,Ndiphenyl-amino)-triphenylamine (TDATA);
- heterozyklischen Oligomeren, insbesondere Oligothiophenen und/oder Oligophenylenvinylenen;
- heterozyklischen Polymeren, insbesondere Polythiophenen, Polyparaphenylen, Polypyrrol und/oder Polyanilin; und/oder
- Kohlenwasserstoffketten, insbesondere Polyacetylen und/oder Polysulfurnitriden;
  sowie hiervon abgeleiteten Derivaten, und/oder die in den Halbleiter eingebettete Elektrode eine Gold- oder Silberelektrode ist.

Zusätzlich zu den vorhandenen Elektroden kann beispielsweise auf der dem Substrat abgewandten Seite der das Copolymer enthaltenden Schicht mindestens eine Elektrode aufgebracht sein, bevorzugt eine Silber- oder Goldelektrode.

Erfindungsgemäß wird ebenso ein Copolymer bereitgestellt, das neben den beiden nachfolgend abgebildeten Wiederholungseinheiten A und B:

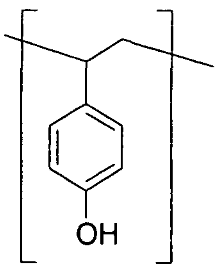

A

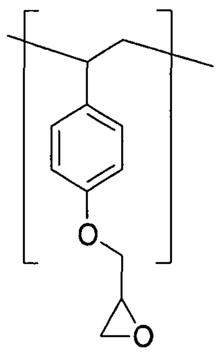

B

zumindest eine der nachfolgend abgebildeten Wiederholungseinheiten C bis H:

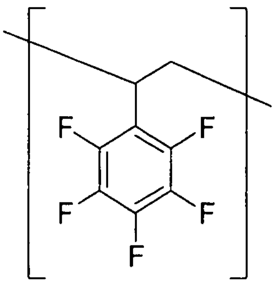 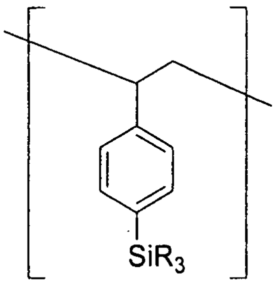 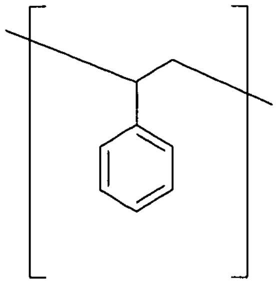

C D E

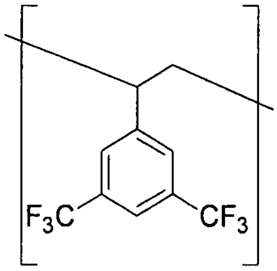 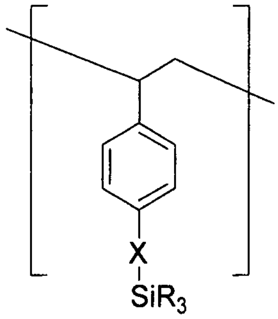 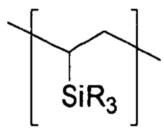

F G H

enthält, wobei

R unabhängig voneinander ausgewählt ist aus der Gruppe bestehend aus linearen oder verzweigten Alkylresten mit 1 bis 8 Kohlenstoffatomen, insbesondere Methyl-, Ethyl-, n-Propyl-, i-Propyl-, n-Butyl-, i-Butyl- und/oder t-Butylresten und/oder linearen oder verzweigten Alkoxyalkylresten mit 1 bis 8 Kohlenstoffatomen, insbesondere -OMe, -OEt, -O(n-Pr), -O(i-Pr), -O(n-Bu), -O(i-Bu), -O(t-Bu), sowie

X ausgewählt ist aus der Gruppe bestehend aus -O- oder $-(CH_2)_x-$, mit $1 \leq x \leq 16$, bevorzugt x = 2.

Bevorzugte Ausführungsformen der oben genannten Copolymere sehen vor, dass das Copolymer aus den Wiederholungseinheiten A, B und Z besteht, wobei Z für die Wiederholungseinheit C, D, E, F, G oder H steht, und jeweils H-terminiert ist, wobei das molare Verhältnis der Wiederholungseinheiten unabhängig voneinander
A/(A+B+Z) zwischen 0,1 und 0,9, bevorzugt zwischen 0,2 und 0,6, besonders bevorzugt zwischen 0,35 und 0,45,
B/(A+B+Z) zwischen 0,05 und 0,8, bevorzugt zwischen 0,2 und 0,4, besonders bevorzugt zwischen 0,325 und 0,225, sowie
Z/(A+B+Z) zwischen 0,05 und 0,45, bevorzugt zwischen 0,2 und 0,4, besonders bevorzugt zwischen 0,325 und 0,225 beträgt,
mit der Maßgabe, dass A+B+Z=1.

Vorteilhaft ist dabei weiter, wenn das Copolymer ein gewichtsgemitteltes Molekulargewicht $M_w$ zwischen 1.000 und 1.000.000 g/mol, bevorzugt zwischen 5.000 und 100.000 g/mol, besonders bevorzugt zwischen 10.000 und 50.000 g/mol aufweist.

Erfindungsgemäß wird weiterhin ein quervernetztes Copolymer bereitgestellt, das sich aus den zuvor definierten (unvernetzten) Copolymeren herstellen lässt. Hierbei findet eine Quervernetzung über Reaktion der Phenolfunktion der Wiederholungseinheit A mit der Epoxygruppe der Wiederholungseinheit B statt. Die Quervernetzung kann dabei thermisch initiiert werden, oder auch photoinitiiert durch UV-Bestrahlung eines entsprechend ausgebildeten Copolymers erfolgen. Dabei findet eine Ringöffnung der Epoxid-Funktionalität der Wiederholungseinheit B unter Addition der alkoholischen Funktionalität der Wiederholungseinheit A statt. Hierbei entsteht ein zweidimensionales Netzwerk, das einerseits aus dem dem Copolymer zugrunde liegenden Polyethylenstrang besteht, der über die entsprechende Quervernetzung zwischen den Wiederholungseinheiten A und B verknüpft wird. Da der Grad der Quervernetzung insbesondere von der Konzentration der Wiederholungseinheiten A und B sowie dem Quervernetzungsgrad abhängt, lässt sich eine

generelle allgemeine Formel für dieses quervernetzte Polymer nicht angeben.

Bezüglich möglicher Architekturen von den erfindungsgemäßen elektronischen Bauteilen, wie z.B. organischen Dünnfilmtransistoren wird auf die nachfolgend dargestellten Figuren 1 bis 3 verwiesen.

Die Figuren 1 bis 3 zeigen organische Dünnschichttransistoren, wie beispielsweise Feldeffekttransistoren, die eine Halbleiterschicht, beispielsweise aus einem oben genannten halbleitenden organischen Material, umfassen. Ebenso umfassen diese Dünnschichttransistoren eine dielektrische Schicht (dielectric), die aus den copolymeren Materialien, die zumindest die Wiederholungseinheiten A und B umfassen, gebildet ist oder diese Copolymere enthält. Mit "S" wird eine Source-Elektrode, mit "D" eine Drain-Elektrode sowie mit "G" eine Ground-Elektrode bezeichnet.

Aus den Figuren 1 bis 3 wird der unterschiedliche Aufbau derartiger Strukturen deutlich, insbesondere können die Source- bzw. Drain-Elektroden in den Halbleiter eingebettet sein, aber auch aus diesem herausragen.

Die in den Figuren 1 bis 3 angedeutete Schichtfolge kann auf einem Substrat angeordnet sein, das bei den Ausführungen gemäß Figuren 1 bis 3 jeweils entweder oberhalb oder unterhalb des dort abgebildeten Stapels angeordnet sein kann.

Die vorliegende Erfindung wird anhand der nachfolgenden Ausführungen näher beschrieben, ohne die Erfindung auf die dort dargestellten speziellen Parameter zu beschränken.

Die erfindungsgemäßen Copolymere weisen mindestens drei oder mehr vernetzbare Gruppen auf, die sich in einem anschließenden thermischen oder auch UV-initiierten Schritt in einer dünnen Schicht (< 100 nm) vernetzen lassen. Dabei wird eine hohe Vernetzungsdichte erzielt, um wirklich elektrisch dichte Schichten zu erzeugen. Außerdem besteht die Möglichkeit, die Hydrophilie und Hydrophobie der Schichtoberfläche durch Einbau weiterer monomerer Wiederholungseinheiten (z.B. die Monomere C-H) in die polymere Kette zu beeinflussen. Es steht somit ein Einkomponentensystem zur Verfügung, welches sich aus Lösung, wie z.B. Spin-Coating, Rakeln oder Drucken, zu ultradünnen Schichten unter normalen Bedingungen verarbeiten lässt. Der anschließende thermische oder auch UV-initiierte Vernetzungsschritt, führt dann zu elektrisch dichten Schichten. Es lassen sich damit sowohl Bottom-Gate als auch Top-Gate-OTFT-Architekturen auf flexiblen (PET-Folien) als auch festen Substraten (Si) realisieren. Im Fall des Top-Gate-Aufbaus besteht der Vorteil der polymeren Lösung auch darin, dass orthogonale stabile Lösungsmittel verwendet werden können, so dass ein Anlösen der bereits abgeschiedenen organischen Halbleiterschicht nicht passiert. Desweiteren lässt sich durch den Einbau von weiteren Monomereinheiten mit z.B. hydrophoben Eigenschaften, wie z.B. Pentafluorbenzyleinheiten, in die polymere Kette die Benetzungsfähigkeit zu der auf der Oberfläche abzuscheidenden Schicht einstellen.

Diese Entwicklung dient vor allem dazu, polymer-elektronische Bauteile kostengünstig zu erzeugen.

Die erfindungsgemäßen Polymere können durch klassische, radikalische Lösungspolymerisation hergestellt werden. Die Copolymere mit Phenol- und Phenoxymethyloxiran-Einheiten können dabei folgende Zusammensetzungen von x = 0.8 und y = 0.2 bis x = 0.2 und y = 0.8 aufweisen. Als hydrophobe Komponenten kann z.B. zusätzlich die Pentafluorbenzyl- oder auch die 4-tert.-Butyldimethylsiloxyphenol-Einheit eingebaut werden. Dabei lassen sich Zusammensetzungen der Terpolymere folgendermaßen einstellen: x = 0.2; y = 0.7, z oder w = 0.1, bis zu x = 0.2, y = 0.2 und z oder w = 0.6. Die so aufgebauten Co- bzw. Terpolymere werden z.B. in Methylethylketon gelöst. In Abhängigkeit von den erzielten Molekulargewichten können Lösungen im Bereich von 0,5 bis 10 Gew.-% hergestellt werden. Danach werden die Lösungen zu dünnen Schichten verarbeitet. Diese dünnen Schichten werden durch Spin-Coating, Rakeln oder auch Drucken erzeugt. Das Aufbringen der Schichten kann sowohl auf festen Trägern, wie z.B. ITO beschichtetem Glas, auf flexiblen Trägern (PET) oder direkt auf dem polymeren Halbleiter erfolgen. In einem anschließenden Schritt werden die Schichten entweder thermisch bei Temperaturen von 120 bis 200°C während eines Zeitraumes von 2 bis 30 min vernetzt. Dieses Verfahren hat den Vorteil, dass kein zusätzlicher Initiator eingebracht werden muss. Durch die Zugabe eines Fotoinitiators, z.B. Diphenyljodoniumtetrafluoroborat oder Triphenylsulfoniumhexafluoroantimonat, kann die Schicht bei wesentlich niedrigeren Temperaturen unter UV-Bestrahlung vernetzt werden. Die Vernetzung erfolgt dann bei Temperaturen, etwa zwischen 100 und 140°C, vorzugsweise bei 120°C.

Es werden Schichtdicken im Bereich von 20 bis 150 nm realisiert. Diese Schichten weisen aufgrund einer hohen Vernetzungsdichte ein sehr gutes dielektrisches Verhalten auf.

**Ausführungsbeispiel**

**Monomersynthesen**

Synthese von 4-Vinylphenol

Das 4-Vinylphenoi wird durch eine basische Verseifung von Acetoxystyrol erhalten.

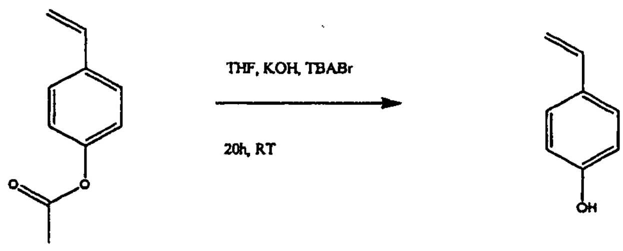


Gleichung 1

In einem 100 ml Kolben werden unter Argoneinleitung 10 g (0,062 Mol) Acetoxystyren in 40 ml THF gelöst. Dazu wird eine Lösung von 3,48 g KOH in 30 ml Wasser und eine Spatelspitze Tetrabutylammoniumbromid gegeben. Die Reaktionslösung wird 20 Stunden bei Raumtemperatur gerührt. Anschließend wird die Reaktionslösung mit Diethylether verdünnt und mehrmals mit Wasser ausgeschüttelt. Die organische Phase wird abgetrennt, über $MgSO_4$ getrocknet und eingeengt. Das Rohprodukt wird mittels Säulenchromatographie (Hexan/- Essigsäureethylester 10:1) gereinigt. Es entstehen 1,2 g (16 % eines weißen Feststoffes; Elementaranalyse: C 79, 99 % ; H 6,67 %).

Synthese von 2-(4-Vinyl-phenoxymethyl)oxiran

Durch Umsetzung des Acetoxystyrols mit Epichlorhydrin unter reduktiven Bedingungen wird das Vinyl-4-Phenoxymethyl-2-oxiran in Anlehnung an die Vorschrift von T. Hashimoto, M. Sawamoto und T. Higashimura, Journal of Polymer Science; Part A: Polymer Chemistry 1987, 23, 2827, synthetisiert.

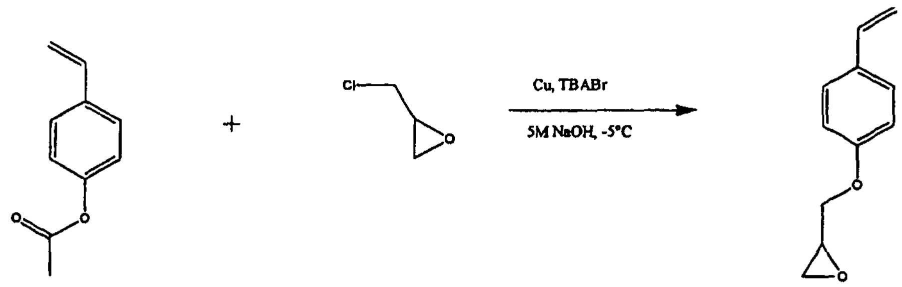


Gleichung 2

In einem 500 ml Dreihalskolben, der mit Thermometer, KPG-Flügelrührer, Inertgaseinleitung und Tropftrichter ausgestattet ist, werden 25 ml (0,163 Mol) 4-Acetoxystyren, 27,4 ml Epichlorhydrin (0,35 Mol), 0,280 g Cu-Pulver (4,4 mmol) und 0,281 g Tetrabutylammoniumbromid (0,874 mmol) vorgelegt und auf -5 °C abgekühlt. 80 ml 5N-Natronlauge sind bei starkem Rühren über den Tropftrichter so langsam zuzugeben, dass die Temperatur der Reaktionsmischung nicht über -5°C ansteigt. Nach erfolgter Zugabe wird für ca. 24 Stunden bei -11°C gerührt, anschließend die Phasen separiert und die wässrige Phase mit Diethylether extrahiert. Die vereinten organischen Phasen werden zweimal mit Wasser gewaschen und über Natriumsulfat getrocknet. Danach werden 2,63 g NaH (0,11 Mol) langsam zugegeben und die Reaktionsmischung über Nacht rühren gelassen. Das nicht umgesetzte NaH wird über eine Fritte mit Kieselgel abgetrennt und mit 3 l Ether gespült. Anschließend erfolgt eine Vakuumdestillation bei einem Druck von 4.6 x $10^{-4}$ mbar, $K_p$. 60 °C. Es werden 10 % eines farblosen Öls isoliert. Die Reinheit wird mittels GSMS untersucht.

In Figur 4 ist ein GCM-Chromatogramm von 2-(4-Vinylphenoxymethyl)oxiran mit 99,3 % Reinheit dargestellt.

**Polymersynthese**

Synthese von Poly(4-vinylphenol-co-2-(4-vinylphenoxymethyl)oxiran (EVP)

Die Polymerisation erfolgt über eine klassische radikalische Initiierung mit AIBN in Lösung. Hier erfolgt die Beschreibung der Polymersynthese stellvertretend für verschiedene Copolymer-Zusammensetzungen.

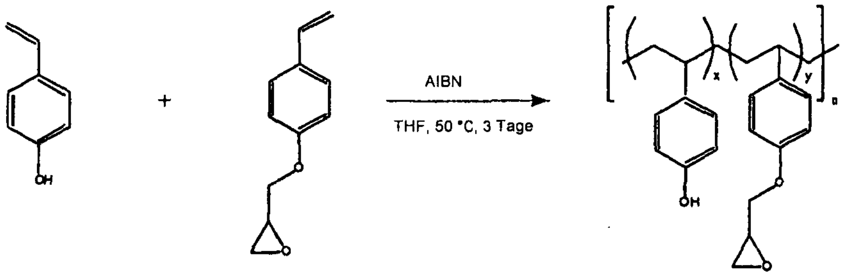


Gleichung 3

Die Polymerisationen werden in der Glovebox durchgeführt. In einem 50 ml 3-Halskolben werden 142,66 mg AIBN, 3,83 g 2-(4-Vinyl-phenoxymethyl)-oxiran (21,72 mmol) und 2,61 g 4-Vinylphenol (21,72 mmol) gelöst in 20 ml THF gegeben. Die Reaktionslösung wird 3 Tage bei 50°C gerührt. Anschließend wird das Polymer in ca. 400 ml Hexan ausgefällt und abfiltriert. Das Polymer wird durch fünfmaliges Umfällen (THF) in Hexan gereinigt. Die Ausbeute betrug 73 %. Das Molekulargewicht wird mittels GPC, gemessen gegen Polystyren in THF, bestimmt.

$M_w$: 15,600 g/mol; $M_n$: 6,300 g/mol; EA:C:76,31 %; H 6,96 %, N 0, 16 %

Aus den Integralen des $^{13}C$-NMR-Spektrums wird die Zusammensetzung des Polymeren bestimmt. Das 2-(4-Vinylphenoxymethyl)-oxiran und das 4-Vinylphenol werden jeweils zu gleichen Teilen in das Polymer eingebaut.

<u>Synthese von Poly(4-vinylphenol-co-2-(4-vinylphenoxymethyl)oxiran-co-vinylpentaflourstyrol</u>

In einem anderen Beispiel wird eine weitere Monomereinheit in das polymere Rückgrad integriert

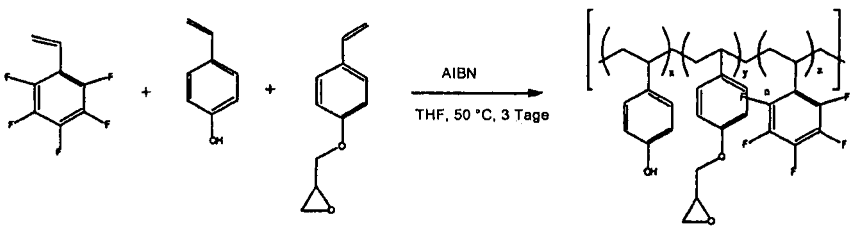


0.33 0.33 0.33

Gleichung 4

Die Polymerisationen werden in der Glovebox durchgeführt. In einem 50 ml 3-Halskolben werden 32,43 mg AIBN, 880 mg 2-(4-Vinyl-phenoxymethyl)-oxiran (5 mmol), 600 mg 4-Vinylphenol (5 mmol) und 970,5 mg Pentafluorstyrol (5 mmol) gelöst in 20 ml THF gegeben. Die Reaktionslösung wird 3 Tage bei 50°C gerührt. Anschließend wird das Polymer in ca. 400 ml Hexan ausgefällt und abfiltriert. Das Polymer wird durch fünfmaliges Umfällen (THF) in Hexan gereinigt. Es werden 1,25 g (56 % Ausbeute) des Polymeren isoliert. Das Molekulargewicht wird auch hier mittels GPC gemessen gegen Polystyren in THF bestimmt.

$M_w$: 30,600 g/ mol; $M_n$: 14,400 g/mol; EA:C:73,24 %; H 8,34 %, N 0,28%.

Aus den Integralen des $^{13}C$-NMR-Spektrums wird die Zusammensetzung des Polymeren bestimmt. Das Pentafluorstyrol wird zu 0,42, das 2-(4-Vinyl-phenoxymethyl)-oxiran und das 4-Vinylphenol zu jeweils gleichen Teilen von 0,29 eingebaut.

**Untersuchungen der Durchschlagfestigkeit in Diodenstrukturen**

Es werden Diodenstrukturen ITO/dielektrisches Polymer (EVP)/Silber mit einer Fläche von ca. 2 $mm^2$ aufgebaut. Dabei wird das Polymer EVP zu 3 Gew.-% in Methylethylketon gelöst. Das Polymer wird auf dem gereinigten ITO gespincoated bei 1000 Umdrehungen pro Minute, dabei wird eine Schichtdicke von 140 nm erreicht, bei Umdrehungsgeschwindigkeiten von 3000 Umdrehungen pro Minute beträgt die Schichtdicke 84 nm. Diese Schichten werden anschließend 30 Minuten bei 120°C und 5 Minuten bei 205°C thermisch behandelt, anschließend wird Silber als Gegenelektrode aufgedampft.

Zur Bestimmung der elektrischen Stabilität des Bauelements wird der Strom in Abhängigkeit der angelegten Spannung zwischen ITO und Silber ermittelt.

In Figur 5 sind die entsprechenden Messungen für EVP-Schichtdicken von 140 und 84 nm graphisch dargestellt. Der Strom ist hierbei unabhängig von der angelegten Spannung, das bedeutet, dass die dielektrische Schicht in diesem Spannungsbereich als elektrisch dicht anzusehen ist.

Figur 5a) zeigt die Strom-Spannungscharakteristik eines Bauelements mit dem Aufbau ITO/EVP/Ag mit einer EVP-Schichtdicke von 140 nm.

Figur 5b) zeigt die Strom-Spannungscharakteristik eines Bauelements mit dem Aufbau ITO/EVP/Ag mit einer EVP-Schichtdicke von 84 nm.

**Präparation der OTFTs auf flexiblen PET-Folien in Top-Gate Architektur**

Als Beispiel werden organische Feldeffekttransistoren als elektronisches Bauelement auf PET-Folien aufgebaut. Nach der Reinigung der PET-Folien in Aceton, deionisiertem-Wasser und Isopropanol und einer Sauerstoff-Plasmabehandlung werden zunächst Source-Drain-Elektroden durch thermische Verdampfung von Gold mittels Schattenmaske im Vakuum ($\approx 10^6$ bar) auf der PET-Folie abgeschieden. Ein thiophenbasierender Polymerhalbleiter wird danach durch Spin-Coating auf die Folie und den Source-Drain-Elektroden abgeschieden und für 30 Minuten bei 80 °C getempert. Das Dielektrikum EVP wird ebenfalls mittels Spin-Coating bei unterschiedlichen Drehgeschwindigkeiten auf dem Halbleiter präpariert und anschließend zunächst für 30 Minuten bei 120 °C gelassen und weiter auf 200°C erwärmt und für weitere 5 Minuten bei 200 °C getempert. Während des Temperungsprozesses erfolgt die thermische Vernetzung des Dielektrikums. Die Gate-Elektrode wird im Anschluss ebenfalls durch thermische Verdampfung von Silber im Vakuum aufgebracht.

**Charakterisierung der OTFTs**

In Figur 6 sind die charakteristischen Kennlinien eines organischen Feldeffekttransistors basierend auf dem Dielektrikum EVP mit einer Schichtdicke von 84 nm dargestellt. Das Verhältnis von Kanalbreite zu Kanallänge lautet wie folgt: W/L = 1000 μm/100 μm.

Figur 6 zeigt eine Transferkennlinie a) und eine Ausganskennlinie b) eines organischen Feldeffekttransistors basierend auf einem vernetzten Dielektrikum mit einer Schichtdicke von 84 nm.

In Tabelle 1 sind die charakteristischen Parameter der Ausgangs- und Transferkennlinie zusammengefasst.

Tabelle 1: Mobilität, Schwellspannung und On/Off-Verhältnis des Transistors aus Figur 6

| Substrat | Mobilität [$cm^2/Vs$] | Schwellspannung [V] | On/Off (- 12 V/0 V) |
|---|---|---|---|
| PET | $2{,}9 \times 10^{-4}$ | - 3,7 | 53 |

Die Gateströme betragen bei diesem Transistor bei einer angelegten Gatespannung von -12 V nur einige $10^{-10}$ A. Diese Ströme sind für Transitoren mit einer entsprechend hohen Ladungsträgermobilität ($\mu > 10^{-2}$ $cm^2/Vs$) ausreichend, um gut funktionierende Bauelemente herzustellen, da dann für diese OTFT-Struktur ein Source-Drain-Strom von mehr als $10^{-7}$ A zu erwarten ist. Der Einfluss des Gatestroms auf den Source-Drain-Strom ist in diesem Fall dann als vernachlässigbar klein anzusehen. Die elektrische Stabilität der 84 nm dicken Dielektrikumsschicht ist somit ausreichend gut. Die Feldeffekteigenschaft des OTFTs in Figur 6 ist ebenfalls sichtbar, jedoch ist die Mobilität des abgeschiedenen Halbleiters in Kombination mit EVP als Dielektrikum zu gering, so dass nur eine kleine Verstärkung des Source-Drain-Stroms erreicht werden kann.

## Patentansprüche

1. Elektronisches Bauteil, umfassend ein Substrat, aufweisend mindestens eine, auf mindestens einer der Oberflächen des Substrats aufgebrachte Schicht umfassend mindestens ein quervernetztes Copolymer, herstellbar durch thermische Quervernetzung bei Temperaturen zwischen 100 und 300 °C und/oder durch photoinitiierte Quervernetzung unter UV-Bestrahlung eines Copolymers, enthaltend zumindest die beiden nachfolgend abgebildeten Wiederholungseinheiten A und B:

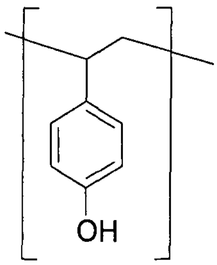

A

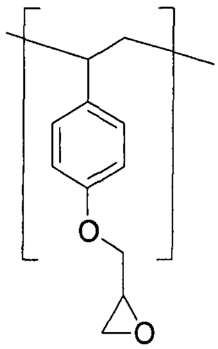

B

**dadurch gekennzeichnet, dass** das Substrat mit einem organischen Halbleiter beschichtet ist, wobei die das Copolymer enthaltende Schicht auf der dem Substrat abgewandten Seite der Halbleiterschicht aufgebracht ist, mit der Maßgabe, dass in die Schicht des organischen Halbleiters oder zwischen der Schicht des organischen Halbleiters und der das Copolymer enthaltenden Schicht mindestens eine Elektrode eingebettet ist.

**2.** Elektronisches Bauteil nach vorhergehendem Anspruch, **dadurch gekennzeichnet, dass** der organische Halbleiter ausgewählt ist aus der Gruppe bestehend aus

• linear kondensierten Ringsystemen, insbesondere Oligoacene, wie Anthracen, Pentacen und dessen Derivate (z. B. Chinacridon) und/oder Benzenthiolate;
• zweidimensional kondensierten Ringsystemen, insbesondere Perylen, 3,4,9,10-Perylentetracarbonsäuredianhydrid (PTCDA) und dessen Derivate, Naphthalin-Derivate und/oder Hexabenzocoronen;
• Metallkomplexen, insbesondere Phthalocyanine, oder Aluminium-tris(8-hydroxychinolin) und/oder Beryllium-bis(hydroxybenzochinolin);
• dendritischen Molekülen, insbesondere 4,4',4"-tris(N,N-diphenyl-amino)-triphenylamine (TDATA);
• heterozyklischen Oligomeren, insbesondere Oligothiophene und/oder Oligophenylenvinylene;
• heterozyklischen Polymeren, insbesondere Polythiophene, Polyparaphenylen, Polypyrrol und/oder Polyanilin; und/oder
• Kohlenwasserstoffkette, insbesondere Polyacetylen und/oder Polysulfurnitriden;
• sowie hiervon abgeleitete Derivaten und/oder die in den Halbleiter eingebettete Elektrode eine Gold- oder Silberelektrode ist.

**3.** Elektronisches Bauteil nach einem der beiden vorhergehenden Ansprüche, **dadurch gekennzeichnet, dass** auf der dem Substrat abgewandten Seite der das Copolymer enthaltenden Schicht mindestens eine Elektrode aufgebracht ist, bevorzugt eine Silber- oder Goldelektrode.

**4.** Elektronisches Bauteil nach einem der Ansprüche 1 bis 3, **dadurch gekennzeichnet, dass**

a) die Schichtdicke der Copolymer enthaltenden Schicht des Substrats zwischen 10 und 1.000 nm, bevorzugt zwischen 20 und 500 nm, besonders bevorzugt zwischen 20 und 150 nm beträgt und/oder
b) das Substrat ausgewählt ist aus der Gruppe bestehend aus Glassubstraten, mit Indium-Zinnoxid beschichteten Glassubstraten, wobei die Copolymer enthaltende Schicht auf der Indium-Zinnoxidschicht aufgebracht ist, Polymersubstraten, bevorzugt folienförmige Polymersubstrate, wobei das Polymer bevorzugt ausgewählt ist aus der Gruppe bestehend aus thermoplastischen Polymeren, insbesondere Polyestern, besonders bevorzugt Polyethylenterephthalat und/oder Silicium-Substraten.

**5.** Elektronisches Bauteil nach einem der Ansprüche 1 bis 4, umfassend ein Substrat, aufweisend mindestens eine, auf mindestens einer der Oberflächen des Substrats aufgebrachte Schicht umfassend mindestens ein quervernetztes Copolymer, herstellbar durch thermische Quervernetzung bei Temperaturen zwischen 100 und 300 °C und/oder durch photoinitiierte Quervernetzung unter UV-Bestrahlung eines Copolymers,
**dadurch gekennzeichnet, dass**
das Copolymer aus den Wiederholungseinheiten A und B

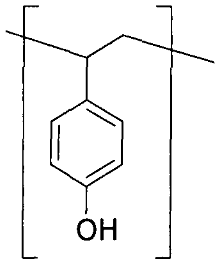

A

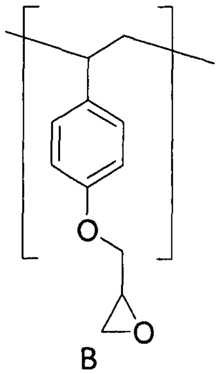

B

besteht und H-terminiert ist, wobei das molare Verhältnis der Wiederholungseinheiten A/(A+B) zwischen 0,1 und 0,9, bevorzugt zwischen 0,2 und 0,8, weiter bevorzugt zwischen 0,4 und 0,6, besonders bevorzugt zwischen 0,45 und 0,55 beträgt, oder das Copolymer zusätzlich zu den Wiederholungseinheiten A und B mindestens eine der nachfolgend abgebildeten Wiederholungseinheiten C bis H:

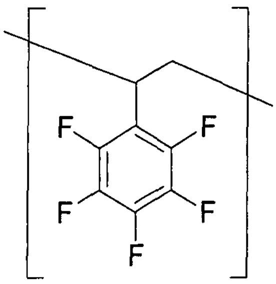

C

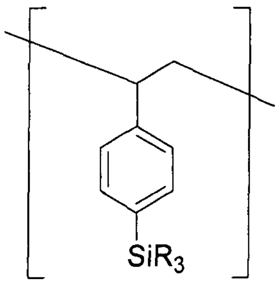

D

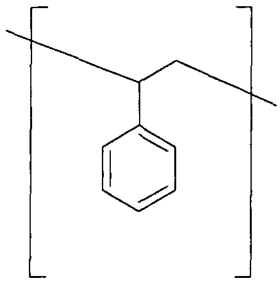

E

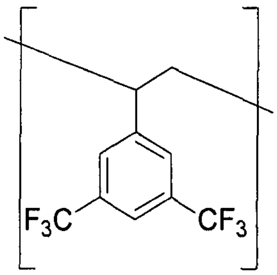

F

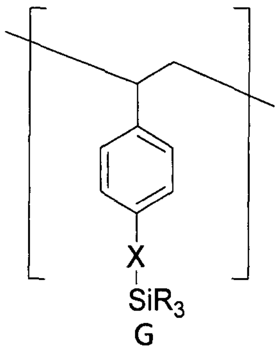

G

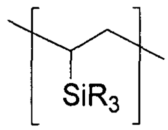

H

umfasst, wobei

R unabhängig voneinander ausgewählt ist aus der Gruppe bestehend aus linearen oder verzweigten Alkylresten mit 1 bis 8 Kohlenstoffatomen, insbesondere Methyl-, Ethyl-, n-Propyl-, i-Propyl-, n-Butyl-, i-Butyl- und/oder t-Butylresten und/oder linearen oder verzweigten Alkoxyalkylresten mit 1 bis 8 Kohlenstoffatomen, insbesondere -OMe, -OEt, -O(n-Pr), -O(i-Pr), -O(n-Bu), -O(i-Bu), -O(t-Bu), sowie
X ausgewählt ist aus der Gruppe bestehend aus
-O- oder $-(CH_2)_x-$, mit $1 \leq x \leq 16$, bevorzugt $x = 2$.

**6.** Copolymer, enthaltend zumindest die beiden nachfolgend abgebildeten Wiederholungseinheiten A und B:

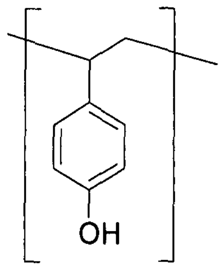
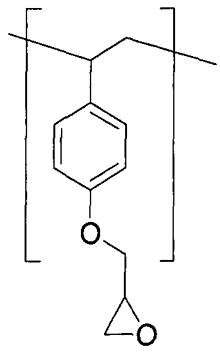

A B

sowie zusätzlich mindestens eine der nachfolgend abgebildeten Wiederholungseinheiten C bis H:

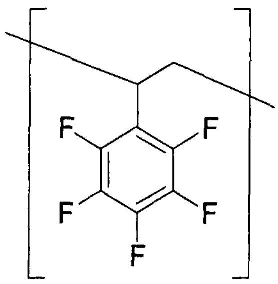
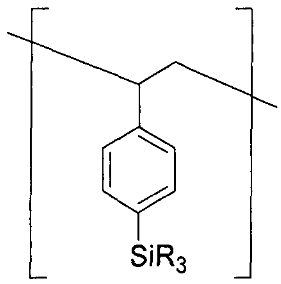
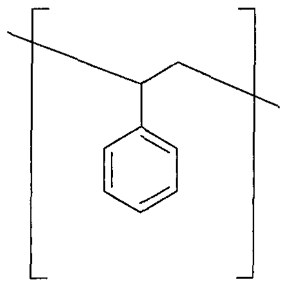

C D E

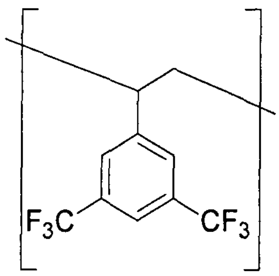
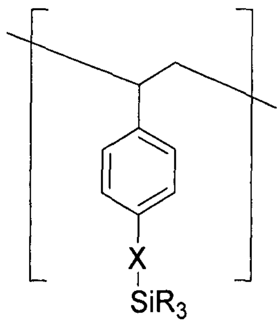
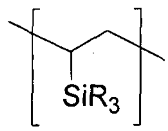

F G H

wobei

R unabhängig voneinander ausgewählt ist aus der Gruppe bestehend aus linearen oder verzweigten Alkylresten mit 1 bis 8 Kohlenstoffatomen, insbesondere Methyl-, Ethyl-, n-Propyl-, i-Propyl-, n-Butyl-, i-Butyl- und/oder t-Butylresten und/oder linearen oder verzweigten Alkoxyalkylresten mit 1 bis 8 Kohlenstoffatomen, insbesondere -OMe, -OEt, -O(n-Pr), -O(i-Pr), -O(n-Bu), -O(i-Bu), -O(t-Bu), sowie
X ausgewählt ist aus der Gruppe bestehend aus -0- oder $-(CH_2)_x-$, mit $1 \leq x \leq 16$, bevorzugt x = 2.

**7.** Copolymer nach vorhergehendem Anspruch, **dadurch gekennzeichnet, dass** das Copolymer aus den Wiederholungseinheiten A, B und Z besteht, wobei Z für die Wiederholungseinheit C, D, E, F, G oder H steht, und jeweils H-terminiert ist, wobei das molare Verhältnis der Wiederholungseinheiten unabhängig voneinander
A/(A+B+Z) zwischen 0,1 und 0,9, bevorzugt zwischen 0,2 und 0,6, besonders bevorzugt zwischen 0,35 und 0,45,
B/(A+B+Z) zwischen 0,05 und 0,8, bevorzugt zwischen 0,2 und 0,4, besonders bevorzugt zwischen 0,325 und 0,225,
sowie

Z/(A+B+Z) zwischen 0,05 und 0,45, bevorzugt zwischen 0,2 und 0,4, besonders bevorzugt zwischen 0,325 und 0,225 beträgt,
mit der Maßgabe, dass A+B+Z=1.

**8.** Copolymer nach einem der beiden vorhergehenden Ansprüche, **gekennzeichnet durch** ein gewichtsgemitteltes Molekulargewicht $M_w$ zwischen 1.000 und 1.000.000 g/mol, bevorzugt zwischen 5.000 und 100.000 g/mol, besonders bevorzugt zwischen 10.000 und 50.000 g/mol.

**9.** Quervernetztes Copolymer, herstellbar durch thermische Quervernetzung bei Temperaturen zwischen 100 und 300 °C und/oder durch photoinitiierte Quervernetzung unter UV-Bestrahlung eines Copolymers nach einem der Ansprüche6 bis 8.

**10.** Substrat, aufweisend mindestens eine, auf mindestens einer der Oberflächen des Substrats aufgebrachte Schicht umfassend mindestens ein quervernetztes Copolymer gemäß dem Anspruch 9.

**11.** Substrat nach vorhergehendem Anspruch, **dadurch gekennzeichnet, dass** die Schichtdicke der Copolymer enthaltenden Schicht zwischen 10 und 1.000 nm, bevorzugt zwischen 20 und 500 nm, besonders bevorzugt zwischen 20 und 150 nm beträgt.

**12.** Substrat nach einem der beiden vorhergehenden Ansprüche, **dadurch gekennzeichnet, dass** das Substrat ausgewählt ist aus der Gruppe bestehend aus Glassubstraten, mit Indium-Zinnoxid beschichteten Glassubstraten, wobei die Copolymer enthaltende Schicht auf der Indium-Zinnoxidschicht aufgebracht ist, Polymersubstraten, bevorzugt folienförmige Polymersubstrate, wobei das Polymer bevorzugt ausgewählt ist aus der Gruppe bestehend aus thermoplastischen Polymeren, insbesondere Polyestern, besonders bevorzugt Polyethylenterephthalat und/oder Silicium-Substraten.

## Claims

**1.** Electronic component, comprising a substrate, having at least one layer applied to at least one of the surfaces of the substrate, which layer comprises at least one crosslinked copolymer, producible by thermal crosslinking at temperatures between 100 and 300°C and/or by photo-initiated crosslinking under UV irradiation of a copolymer, containing at least the two repeating units A and B shown below:

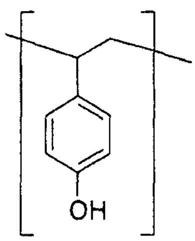
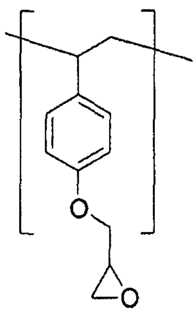

A B

**characterised in that** the substrate is coated with an organic semiconductor, the layer containing the copolymer being applied to the side of the semiconductor layer facing away from the substrate, with the proviso that at least one electrode is embedded in the layer of the organic semiconductor or between the layer of the organic semiconductor and the layer containing the copolymer.

**2.** Electronic component according to the preceding claim, **characterised in that** the organic semiconductor is selected from the group consisting of

- linearly condensed ring systems, in particular oligoacenes, such as anthracene, pentacene and its derivatives (e.g. quinacridone) and/or benzenethiolates;
- two-dimensionally condensed ring systems, in particular perylene, 3,4,9,10-perylenetetracarboxylic dianhydride (PTCDA) and its derivatives, naphthalene derivatives and/or hexabenzocoronenes;
• metal complexes, in particular phthalocyanines, or aluminium-tris(8-hydroxyquinoline) and/or beryllimium-bis(hydroxybenzoquinoline);
• dendritic molecules, in particular 4,4',4"-tris(N,N-diphenyl-amino)-triphenylamines (TDATA);
• heterocyclic oligomers, in particular oligothiophenes and/or oligophenylene vinylenes;
• heterocyclic polymers, in particular polythiophenes, polyparaphenylene, polypyrrole and/or polyaniline; and/or
• hydrocarbon chain, in particular polyacetylene and/or polysulphur nitrides;
• as well as derivatives derived therefrom and/or the electrode embedded in the semiconductor is a gold or silver electrode.

**3.** Electronic component according to one of the two preceding claims, **characterised in that** at least one electrode, preferably a silver or gold electrode, is applied on the side, facing away from the substrate, of the layer containing the copolymer.

**4.** Electronic component according to one of Claims 1 to 3, **characterised in that**

a) the layer thickness of the copolymer-containing layer of the substrate is between 10 and 1,000 nm, preferably between 20 and 500 nm, particularly preferably between 20 and 150 nm and/or
b) the substrate is selected from the group consisting of glass substrates, indium-tin oxide coated glass substrates, the copolymer-containing layer being applied to the indium-tin oxide layer, polymer substrates, preferably polymer substrates in the form of films, the polymer preferably being selected from the group consisting of thermoplastic polymers, in particular polyesters, particularly preferably polyethylene terephthalate and/or silicon substrates.

**5.** Electronic component according to one of Claims 1 to 4, comprising a substrate, having at least one layer applied to at least one of the surfaces of the substrate, which layer comprises at least one crosslinked copolymer, producible by thermal crosslinking at temperatures between 100 and 300°C and/or by photo-initiated crosslinking under UV irradiation of a copolymer,
**characterised in that** the copolymer consists of the repeating units A and B

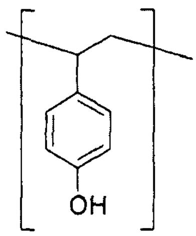
A

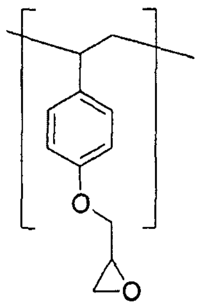
B

and is H-terminated, the molar ratio of the repeating units A/(A+B) being between 0.1 and 0.9, preferably between 0.2 and 0.8, more preferably between 0.4 and 0.6, particularly preferably between 0.45 and 0.55, or the copolymer comprises, in addition to the repeating units A and B, at least one of the repeating units C to H shown below:

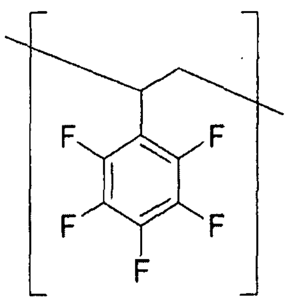
C

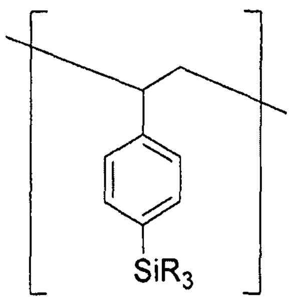
D

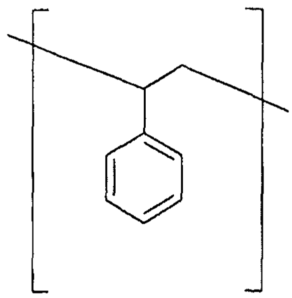
E

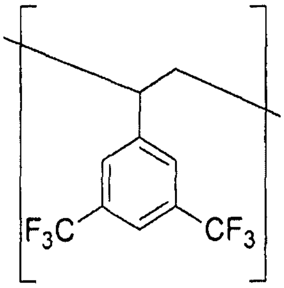

F

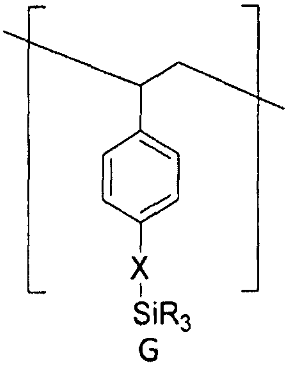

G

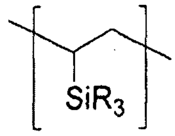

H

R being selected independently from one another from the group consisting of linear or branched alkyl radicals having 1 to 8 carbon atoms, in particular methyl, ethyl, n-propyl, i-propyl, n-butyl, i-butyl and/or t-butyl radicals and/or linear or branched alkoxyalkyl radicals having 1 to 8 carbon atoms, in particular -OMe, -OEt, -O(n-Pr), -O(i-Pr), -O(n-Bu), -O(i-Bu), -O(t-Bu), and

X being selected from the group consisting of -O- or $-(CH_2)_x$-, with $1 \leq x \leq 16$, preferably x = 2.

**6.** Copolymer, containing at least the two repeating units A and B shown below:

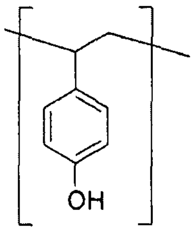

A

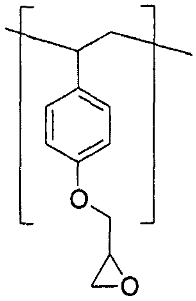

B

and additionally at least one of the repeating units C to H shown below:

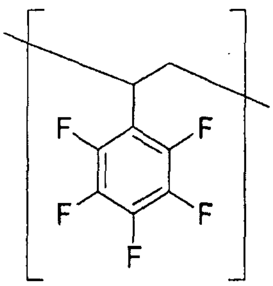

C

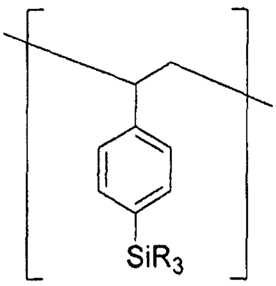

D

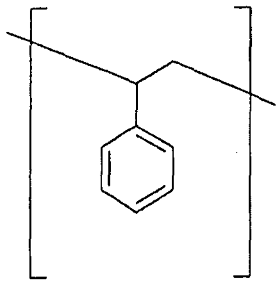

E

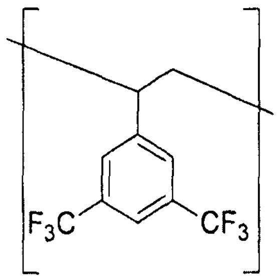

F

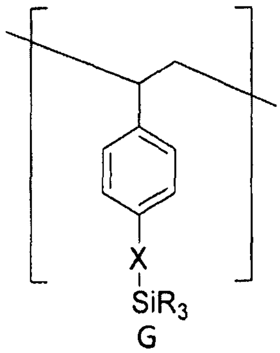

G

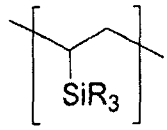

H

R being selected independently from one another from the group consisting of linear or branched alkyl radicals having 1 to 8 carbon atoms, in particular methyl, ethyl, n-propyl, i-propyl, n-butyl, i-butyl and/or t-butyl radicals and/or linear or branched alkoxyalkyl radicals having 1 to 8 carbon atoms, in particular -OMe, OEt, O(n-Pr), -O(i-Pr), -O(n-Bu), -O(i-Bu), -O(t-Bu), and
X being selected from the group consisting of -O- or $-(CH_2)_x-$, with $1 \leq x \leq 16$, preferably x = 2.

7. Copolymer according to the preceding claim, **characterised in that** the copolymer consists of the repeating units A, B and Z, Z representing the repeating unit C, D, E, F, G or H, and in each case is H-terminated, the molar ratio of the repeating units being, independently of one another,
A/(A+B+Z) between 0.1 and 0.9, preferably between 0.2 and 0.6, particularly preferably between 0.35 and 0.45,
B/(A+B+Z) between 0.05 and 0.8, preferably between 0.2 and 0.4, particularly preferably between 0.325 and 0.225, and
Z/(A+B+Z) between 0.05 and 0.45, preferably between 0.2 and 0.4, particularly preferably between 0.325 and 0.225, with the proviso that A+B+Z=1.

8. Copolymer according to one of the two preceding claims, **characterised by** a weight-averaged molecular weight $M_w$ between 1,000 and 1,000,000 g/mol, preferably between 5,000 and 100,000 g/mol, particularly preferably between 10,000 and 50,000 g/mol.

9. Crosslinked copolymer, producible by thermal crosslinking at temperatures between 100 and 300°C and/or by photo-initiated crosslinking under UV irradiation of a copolymer according to one of Claims 6 to 8.

10. Substrate, having at least one layer applied to at least one of the surfaces of the substrate, comprising at least one crosslinked copolymer according to Claim 9.

11. Substrate according to the preceding claim, **characterised in that** the layer thickness of the copolymer-containing layer is between 10 and 1,000 nm, preferably between 20 and 500 nm, particularly preferably between 20 and 150 nm.

12. Substrate according to one of the two preceding claims, **characterised in that** the substrate is selected from the group consisting of glass substrates, indium-tin oxide coated glass substrates, the copolymer-containing layer being applied to the indium-tin oxide layer, polymer substrates, preferably polymer substrates in the form of films, the polymer preferably being selected from the group consisting of thermoplastic polymers, in particular polyesters, particularly preferably polyethylene terephthalate and/or silicon substrates.

## Revendications

1. Composant électronique, présentant un substrat, présentant au moins une couche appliquée sur au moins l'une des surfaces du substrat, comprenant au moins un copolymère réticulé, pouvant être fabriqué par réticulation thermique à des températures comprises entre 100 et 300°C et/ou par réticulation photo-amorcée sous rayonnement UV d'un copolymère contenant au moins les deux motifs répétitifs A et B présentés ci-après :

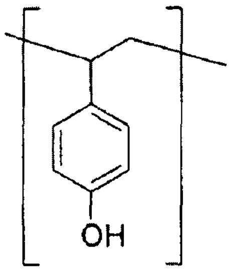

A

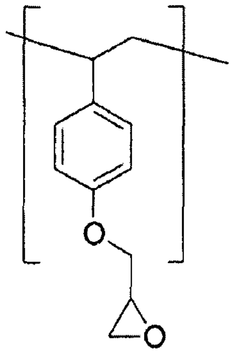

B

**caractérisé en ce que** le substrat est revêtu d'un semi-conducteur organique, la couche contenant le copolymère étant appliquée sur la face de la couche de semi-conducteur opposée au substrat, à la condition qu'au moins une électrode soit incorporée dans la couche du semi-conducteur organique ou entre la couche du semi-conducteur organique et la couche contenant le copolymère.

**2.** Composant électronique selon la revendication précédente, **caractérisé en ce que** le semi-conducteur organique est choisi dans le groupe consistant en

- les systèmes cycliques condensés linéaires, en particulier les oligoacènes tels que l'anthracène, le pentacène et ses dérivés (p.ex. la quinacridone) et/ou les benzènethiolates ;
- les systèmes cycliques condensés bidimensionnels, en particulier le pérylène, le dianhydride 3,4,9,10-pérylènetétracarboxylique (PTCDA) et ses dérivés, les dérivés du naphtalène et/ou l'hexabenzocoronène ;
- les complexes métalliques, en particulier les phtalocyanines, ou l'aluminium-tris(8-hydroxyquinoléine) et/ou la bérylliumbis(hydroxybenzoquinoléine) ;
- les molécules dendritiques, en particulier la 4,4',4"-tris(N,N-diphényl-amino)-triphénylamine (TDATA) ;
- les oligomères hétérocycliques, en particulier les oligothiophènes et/ou les oligophénylènevinylènes ;
- les polymères hétérocycliques, en particulier les polythiophènes, le polyparaphénylène, le polypyrrole et/ou la polyaniline ; et/ou
- une chaîne hydrocarbonée, en particulier le polyacétylène et/ou les poly(nitrures de soufre) ;
- ainsi que les dérivés obtenus à partir de ceux-ci, et/ou que l'électrode incorporée dans le semi-conducteur est une électrode en or ou en argent.

**3.** Composant électronique selon l'une des deux revendications précédentes, **caractérisé en ce qu'**une électrode, de préférence une électrode en argent ou en or, est appliquée sur la face opposée au substrat de la couche contenant le copolymère.

**4.** Composant électronique selon l'une des revendications 1 à 3, **caractérisé en ce que**

a) l'épaisseur de couche de la couche du substrat contenant le copolymère est comprise entre 10 et 1000 nm, de préférence entre 20 et 500 nm, d'une manière particulièrement préférée entre 20 et 150 nm, et/ou
b) le substrat est choisi dans le groupe consistant en les substrats de verre, les substrats de verre revêtus d'oxyde d'indium et d'étain, la couche contenant le copolymère étant appliquée sur la couche d'oxyde d'indium et d'étain, les substrats polymères, de préférence les substrats polymères en forme de feuille, le polymère étant de préférence choisi dans le groupe consistant en les polymères thermoplastiques, en particulier les polyesters, d'une manière particulièrement préférée le poly(téréphtalate d'éthylène) et/ou les substrats de silicium.

**5.** Composant électronique selon l'une des revendications 1 à 4, comprenant un substrat présentant au moins une couche appliquée sur au moins l'une des surfaces du substrat, comprenant au moins un copolymère réticulé, pouvant être fabriqué par réticulation thermique à des températures comprises entre 100 et 300°C et/ou par réticulation photo-amorcée sous rayonnement UV d'un copolymère,
**caractérisé en ce que**
le copolymère est constitué des motifs répétitifs A et B

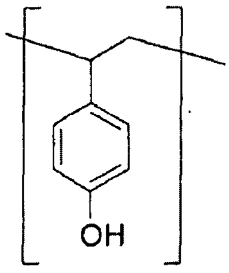

A

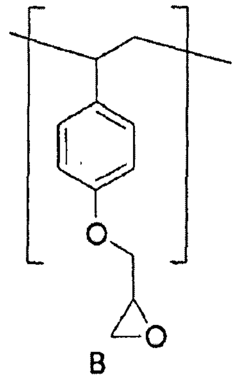

B

et est à terminaison H, le rapport en moles des motifs répétitifs A/(A+B) étant compris entre 0,1 et 0,9, de préférence entre 0,2 et 0,8, d'une manière plus préférée entre 0,4 et 0,6, d'une manière particulièrement préférée entre 0,45 et 0,55, ou

le copolymère comprend, en plus des motifs répétitifs A et B, au moins l'un des motifs répétitifs C à H présentés ci-après

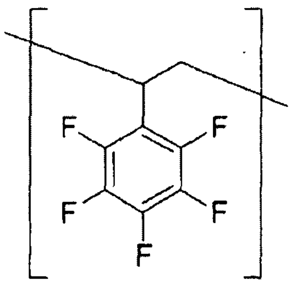

C

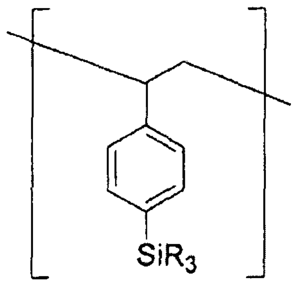

D

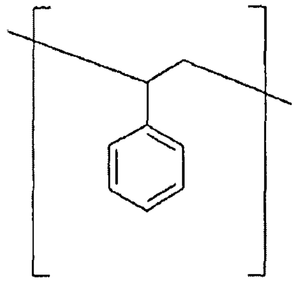

E

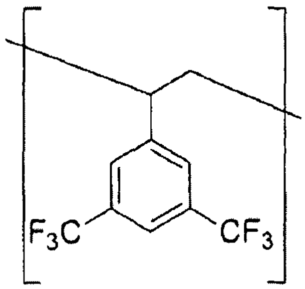

F

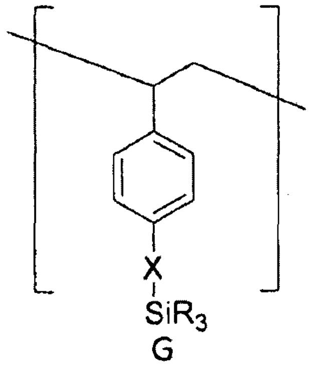

G

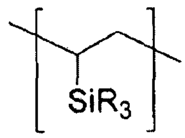

H

où

les radicaux R sont choisis indépendamment les uns des autres dans le groupe consistant en les radicaux alkyle à chaîne droite ou ramifiée ayant 1 à 8 atomes de carbone, en particulier les radicaux méthyle, éthyle, n-propyle, isopropyle, n-butyle, isobutyle et/ou tert-butyle, et/ou les radicaux alcoxyalkyle à chaîne droite ou ramifiée ayant 1 à 8 atomes de carbone, en particulier -OMe, -OEt, -O(n-Pr), - O(i-Pr), -O(n-Bu), -O(i-Bu), -O(t-Bu), ainsi que

X est choisi dans le groupe consistant en -O- ou $-(CH_2)_x-$, avec $1 \leq x \leq 16$, de préférence x = 2.

**6.** Copolymère contenant au moins les deux motifs répétitifs A et B présentés ci-après :

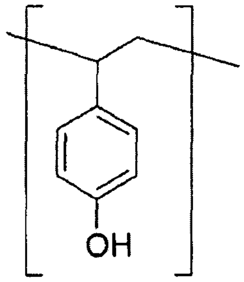

A

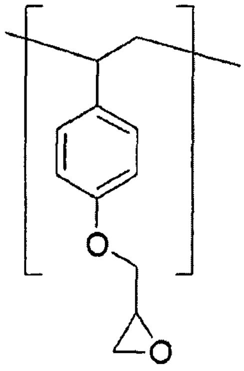

B

ainsi qu'en outre au moins l'un des motifs répétitifs C à H présentés ci-après :

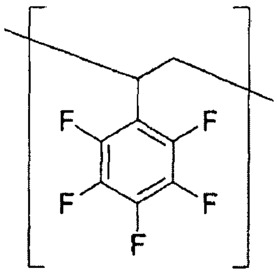

C

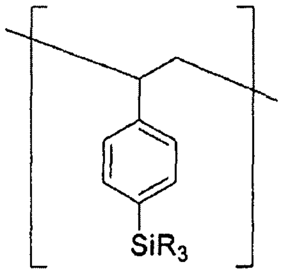

D

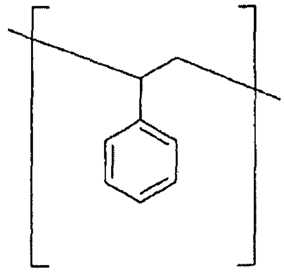

E

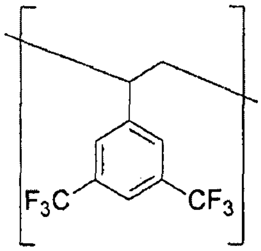

F

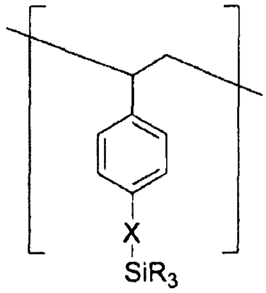

G

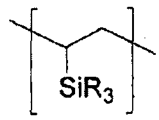

H

où

les radicaux R sont choisis indépendamment les uns des autres dans le groupe consistant en les radicaux alkyle à chaîne droite ou ramifiée ayant 1 à 8 atomes de carbone, en particulier les radicaux méthyle, éthyle, n-propyle, isopropyle, n-butyle, isobutyle et/ou tert-butyle, et/ou les radicaux alcoxyalkyle à chaîne droite ou ramifiée ayant 1 à 8 atomes de carbone, en particulier -OMe, -OEt, -O(n-Pr), - O(i-Pr), -O(n-Bu), -O(i-Bu), -O(t-Bu), ainsi que
X est choisi dans le groupe consistant en -O- ou $-(CH_2)_x-$, avec $1 \leq x \leq 16$, de préférence x = 2.

7. Copolymère selon l'une des revendications précédentes, **caractérisé en ce que** le copolymère est constitué des motifs répétitifs A, B et Z, Z représentant le motif répétitif C, D, E, F, G ou H, les rapports en moles des motifs répétitifs étant, indépendamment les uns des autres, les suivants :

A/(A+B+Z) compris entre 0,1 et 0,9, de préférence entre 0,2 et 0,6, d'une manière particulièrement préférée entre 0,35 et 0,45,

B/(A+B+Z) compris entre 0,05 et 0,8, de préférence entre 0,2 et 0,4, d'une manière particulièrement préférée entre 0,325 et 0,225,
ainsi que
Z/(A+B+Z) compris entre 0,05 et 0,45, de préférence entre 0,2 et 0,4, d'une manière particulièrement préférée entre 0,325 et 0,225,
à la condition que A+B+Z = 1.

**8.** Copolymère selon l'une des revendications précédentes, **caractérisé par** une masse moléculaire moyenne en masse $M_w$ comprise entre 1000 et 1 000 000 g/mol, de préférence entre 5000 et 100 000 g/mol, d'une manière particulièrement préférée entre 10 000 et 50 000 g/mol.

**9.** Copolymère réticulé pouvant être fabriqué par réticulation thermique à des températures comprises entre 100 et 300°C et/ou par réticulation photo-amorcée sous rayonnement UV d'un copolymère selon l'une des revendications 6 à 8.

**10.** Substrat présentant au moins une couche appliquée sur au moins l'une des surfaces du substrat, comprenant au moins un copolymère réticulé selon la revendication 9.

**11.** Substrat selon la revendication précédente, **caractérisé en ce que** l'épaisseur de couche de la couche contenant le copolymère est comprise entre 10 et 1000 nm, de préférence entre 20 et 500 nm, d'une manière particulièrement préférée entre 20 et 150 nm.

**12.** Substrat selon l'une des revendications précédentes, **caractérisé en ce que** le substrat est choisi dans le groupe consistant en les substrats de verre, les substrats de verre revêtus d'oxyde d'indium et d'étain, la couche contenant le copolymère étant appliquée sur la couche d'oxyde d'indium et d'étain, les substrats polymères, de préférence les substrats polymères en forme de feuille, le polymère étant de préférence choisi dans le groupe consistant en les polymères thermoplastiques, en particulier les polyesters, d'une manière particulièrement préférée le poly(téréphtalate d'éthylène) et/ou les substrats de silicium.

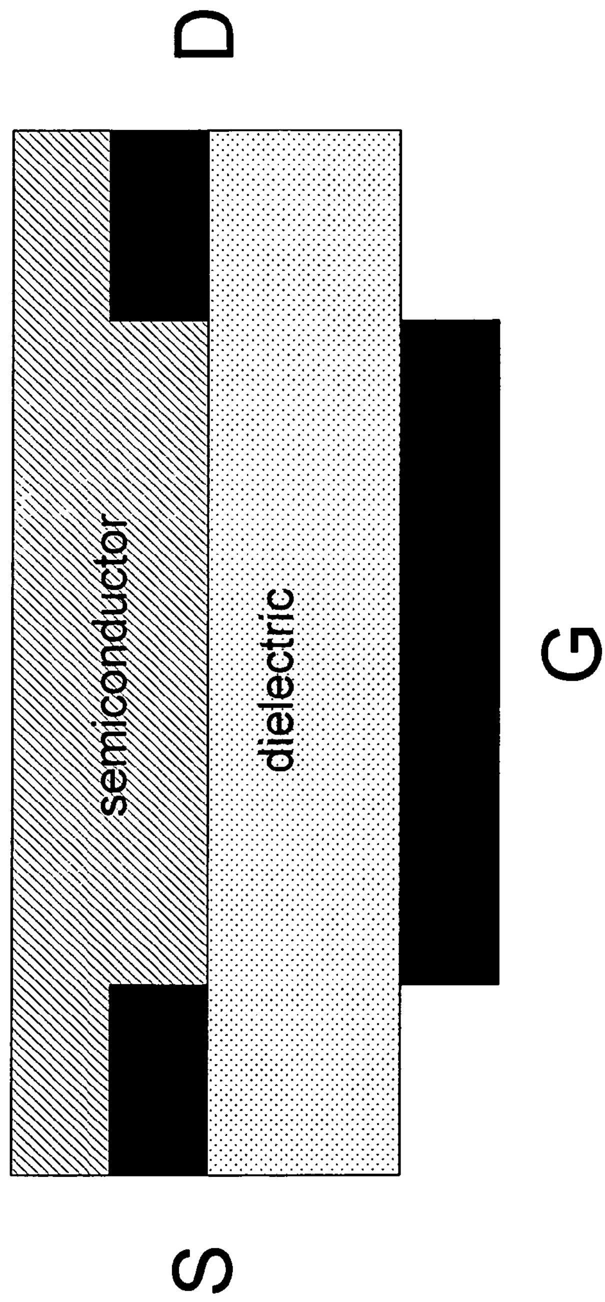


Figur 1

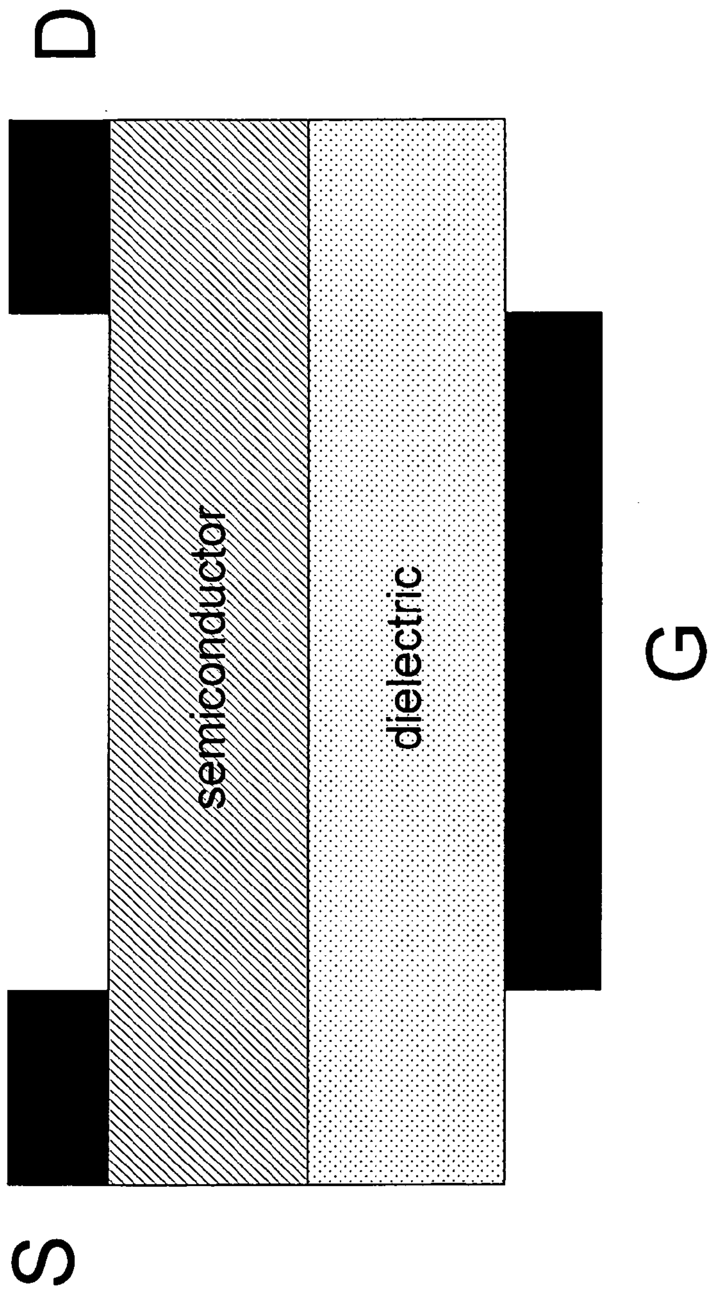


Figur 2

Figur 3

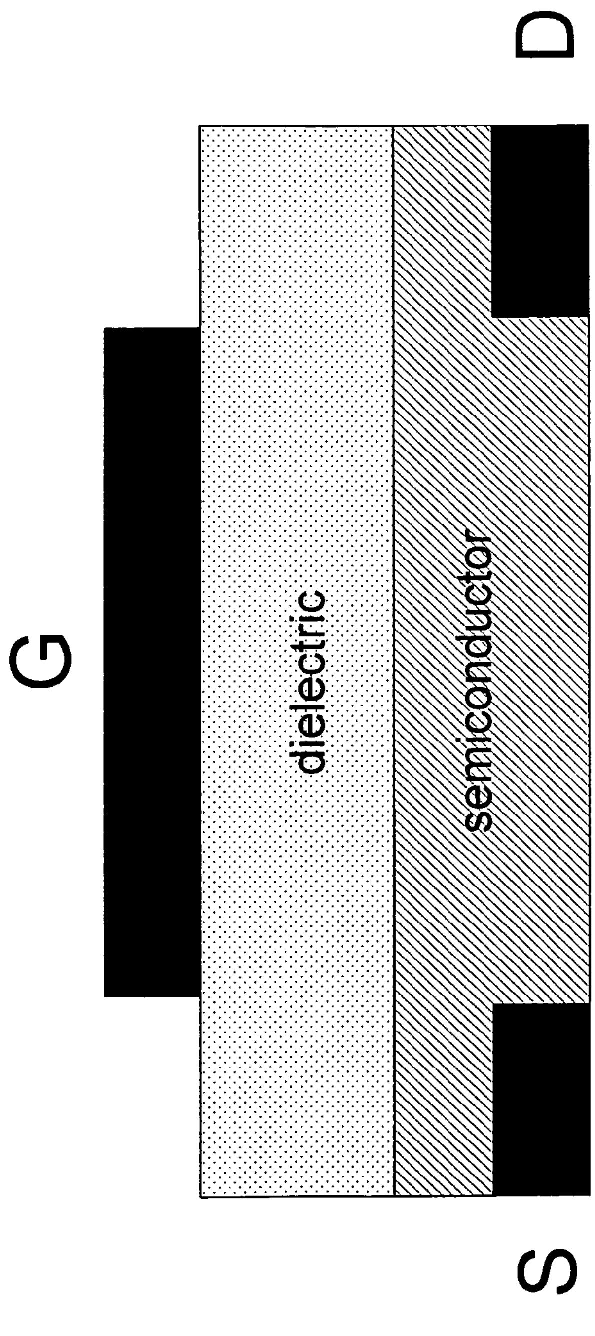

Figur 4a

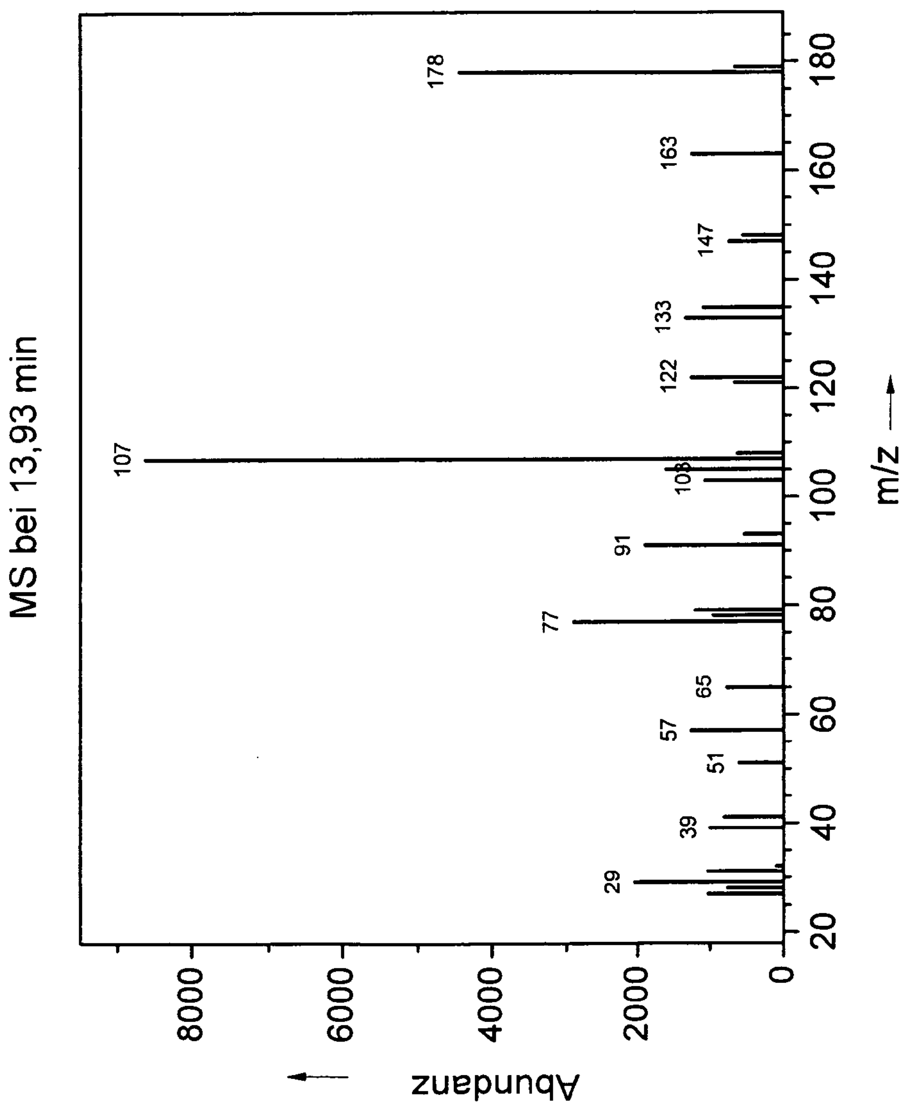
MS bei 13,93 min
Abundanz
m/z
0
2000
4000
6000
8000
20
40
60
80
100
120
140
160
180
29
39
51
57
65
77
91
107
122
133
147
163
178

Figur 4b

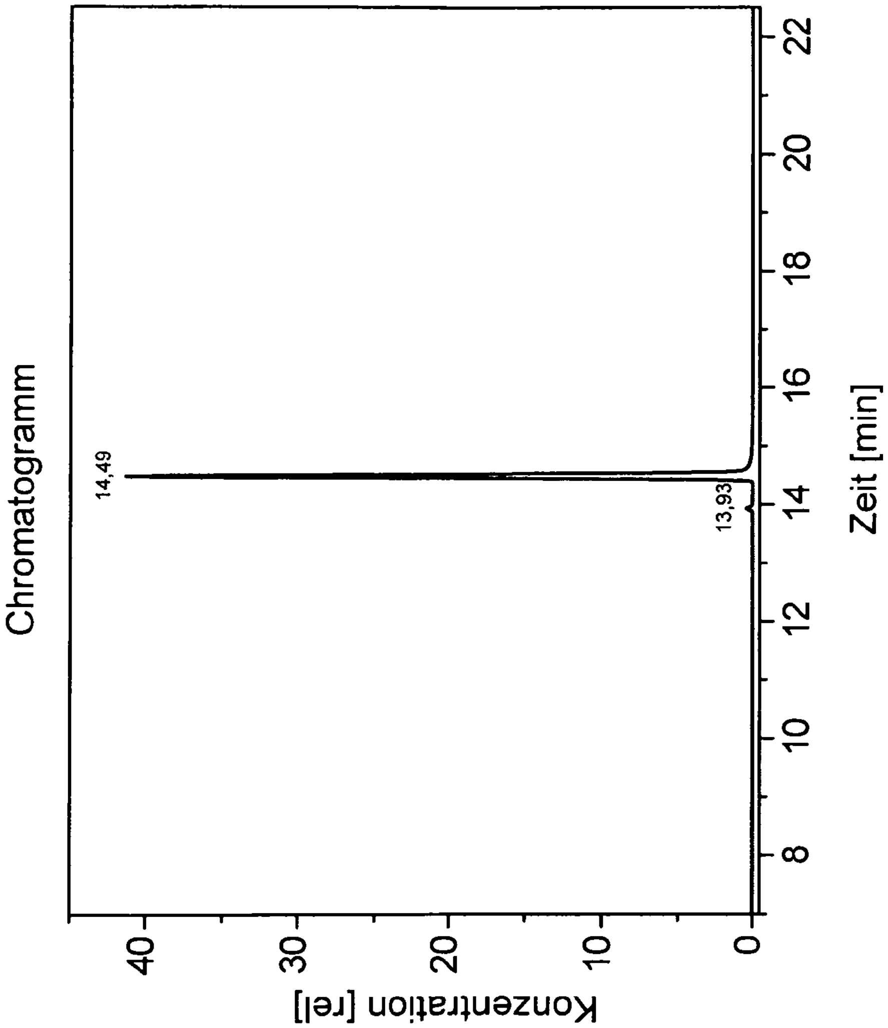
Chromatogramm
14,49
13,93
Konzentration [rel]
0
10
20
30
40
Zeit [min]
8
10
12
14
16
18
20
22

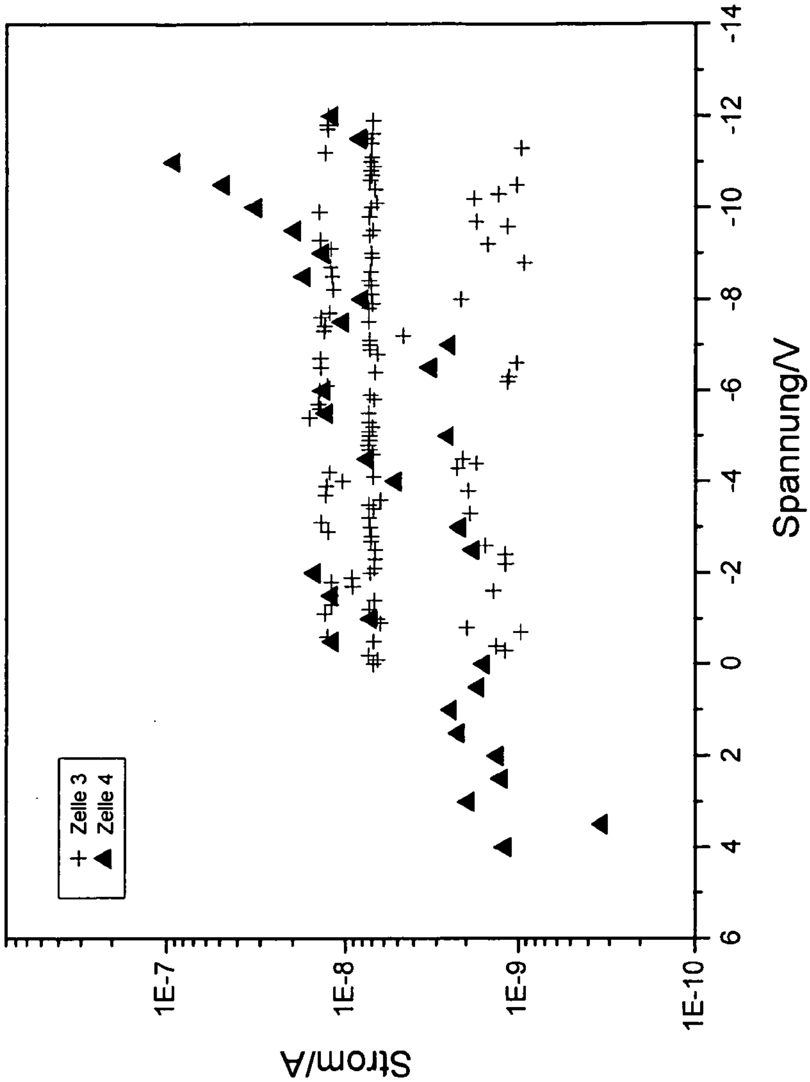
Strom/A
1E-7
1E-8
1E-9
1E-10
Spannung/V
6
4
2
0
-2
-4
-6
-8
-10
-12
-14
Zelle 3
Zelle 4

Figur 5a

Figur 5b

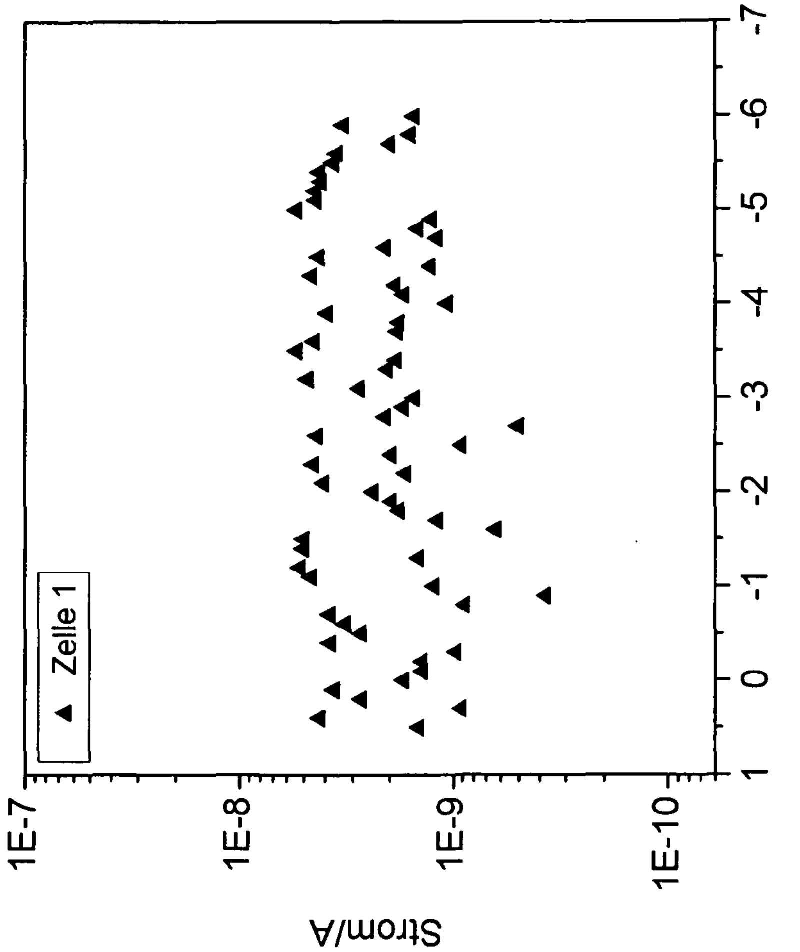

Figur 6a

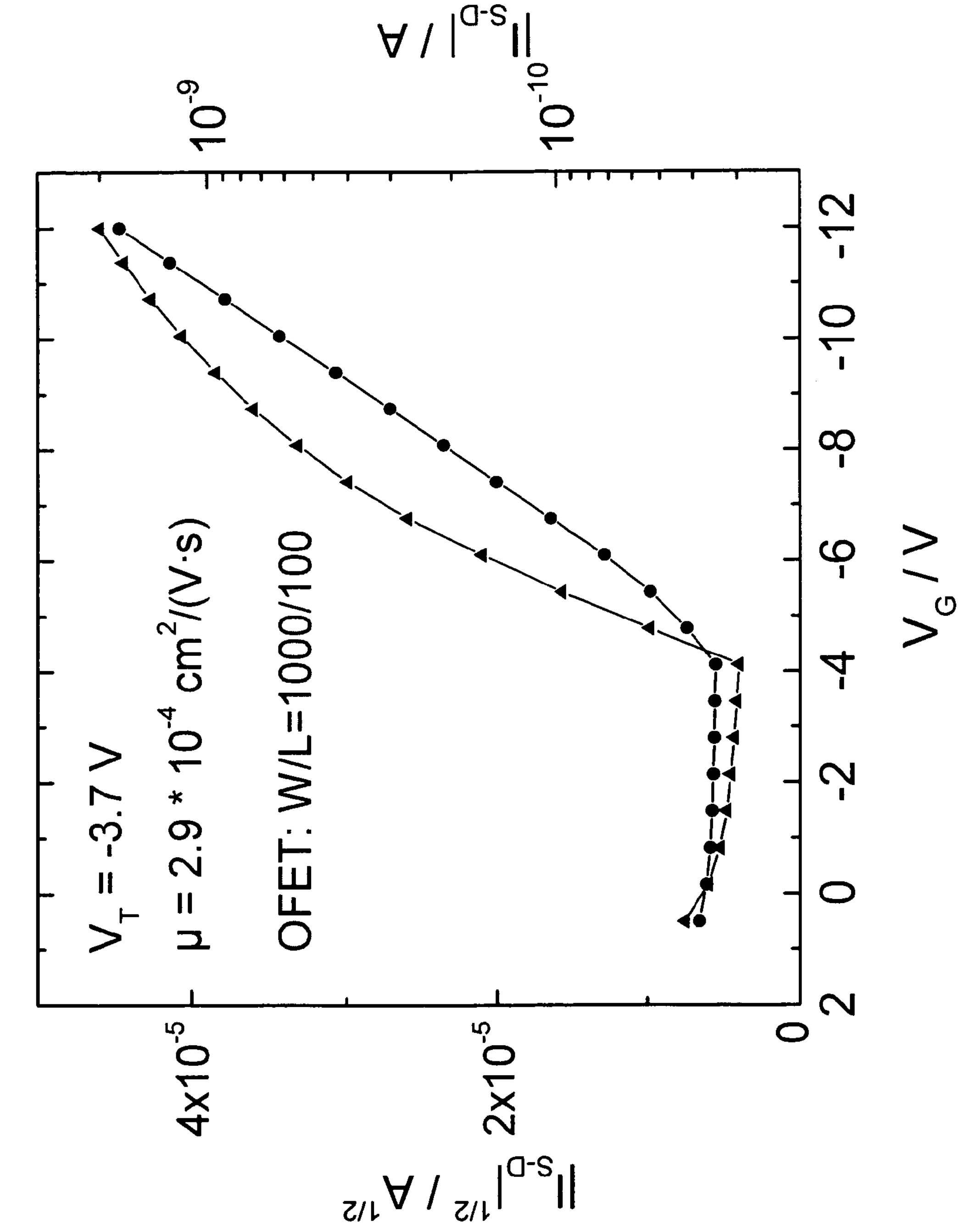
V_T = -3.7 V
μ = 2.9 * 10^-4 cm^2/(V·s)
OFET: W/L=1000/100
V_G / V
|I_S-D|^1/2 / A^1/2
|I_S-D| / A
10^-9
10^-10
4x10^-5
2x10^-5
0
2
0
-2
-4
-6
-8
-10
-12

Figur 6b

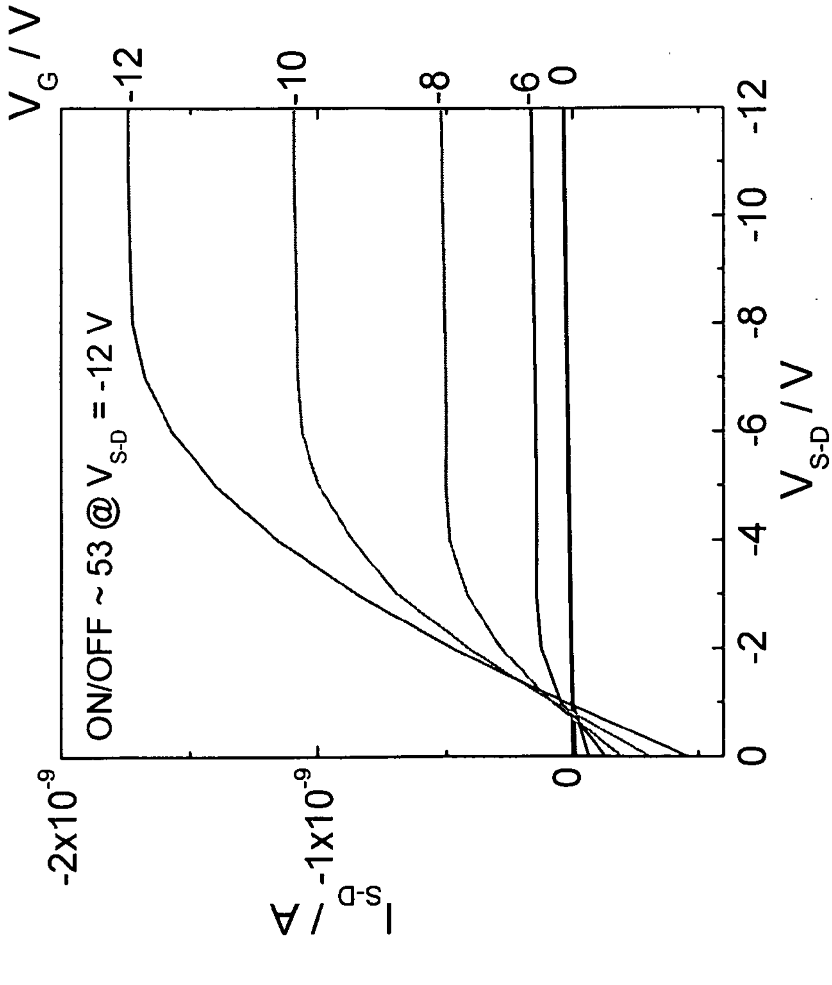

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 20080161464 A1
- WO 2006086082 A2
- DE 102007044872 A1
- JP 60134234 A


### In der Beschreibung aufgeführte Nicht-Patentliteratur


- **T. J. MARKS ; A. FACCHETTI ; Z. WANG ; H.-J. CHOI.** *Organic Electronics,* 2009, vol. 10, 174
- **Y.-Y. NOH ; H. SIRRINGHAUS.** *J. am. Chem. Soc.,* 2008, vol. 130, 6878
- **T. J. MARKS ; A. FACCHETTI ; Z. WANG ; H.-J. CHOI ; C. KIM ; Y.-G. HA.** *Adv. Mat'.,* 2005, vol. 17, 1705
- **A. FACCHETTI ; M.-H. YOON ; T. J. MARKS.** *J. am. Chem. Soc.,* 2005, vol. 127, 10388
- **M. KLAUK ; M. HALIK ; U. ZSCHIESCHANG ; G. SCHMID ; C. DEHM ; M. SCHÜTZ ; ST. MAISCH ; F. EFFENBERGER ; M. BRUNNBAUER ; F. STELLACCI.** *Nature,* 2004, vol. 431, 963
- **H. KLAUK, U. ZSCHIESCHANG, U. HALIK, U. PFLAUM.** *Nature,* 2007, vol. 445, 745
- *J. of Phys. Chem. A,* 2007, vol. 111, 12333
- **M. MCDOWELL ; I. G. HILL ; J. HWANG ; A. KAHN ; S. L. BERNASEK ; J. SCHWARTZ.** *J. E. McDermott*
- **T. HASHIMOTO ; M. SAWAMOTO ; T. HIGASHIMURA.** *Journal of Polymer Science; Part A: Polymer Chemistry,* 1987, vol. 23, 2827